# EUROPEAN PATENT APPLICATION

(11) **EP 4 563 608 A1**
(43) Date of publication of application: **04.06.2025**
(21) Application number: 23846173.5
(22) Date of filing: 06.07.2023
(51) Int. Cl.: C08F 290/06, C09D 133/06, C09D 143/04, C09D 183/10, C09K 3/00, G02B 5/20, G03F 7/004, G03F 7/075

(54) **SILICONE-CONTAINING COPOLYMER, LEVELING AGENT, COATING COMPOSITION, RESIST COMPOSITION, COLOR FILTER, AND SILICONE-CONTAINING COPOLYMER PRODUCTION METHOD**

(30) Priority: 29.07.2022 JP 2022121722
(71) Applicant: DIC Corporation, Tokyo 174-8520 (JP)
(72) Inventor: UENO, Junpei, Ichihara-shi, Chiba 290-8585 (JP)
(74) Representative: TBK
(86) International application number: PCT/JP2023/025057
(87) International publication number: WO 2024/024441

(57) **Abstract**

Provided is a silicone-containing copolymer that is capable of reducing an environmental burden and gives an effect of suppressing the occurrence of foreign substances due to the sublimation of a pigment on the surface of a coated film. Specifically, the silicone-containing copolymer contains: a polymerizable monomer (A) having a group represented by General Formula (a) described below; and a polymerizable monomer (B) having a group including a cyclic hydrocarbon skeleton, as at least a polymerization component.

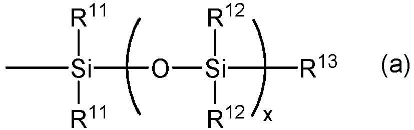

## Description

### TECHNICAL FIELD

The present invention relates to a silicone-containing copolymer, a leveling agent, a coating composition, a resist composition, a color filter, and a method for producing a silicone-containing copolymer.

### BACKGROUND ART

A color filter used in a color liquid crystal display or the like, in general, has a basic configuration including each pixel of red (R), green (G), and blue (B), and a black matrix (BM) formed between the pixels to improve display contrast or the like.

The surface of each pixel of R, G, and B and BM in the color filter is required to have high smoothness, and thus, when applying a color resist composition, it is necessary to apply the color resist composition with an even film thickness and without causing application unevenness, cissing, and color unevenness.

A leveling agent is added to smooth a coated film obtained by the coating of a coating composition such as a coating material composition and a color resist composition. Specifically, by adding the leveling agent to the color resist composition, the smoothness of the coated film to be obtained is improved, and high smoothness of the surface of the pixels of red (R), green (G), and blue (B), and the black matrix (BM) formed between the pixels can be exhibited, and thus, the color unevenness of the color filter can be reduced.

In addition, there is a demand for the color filter to have a desired color phase in each pixel of red, green, and blue. In such a demand, for example, a pigment excellent in brightness, such as C.I. Pigment Red 254 or C.I. Pigment Yellow 139, has a property that the pigment is easily sublimated in a drying step of the coated film containing the pigment, and easily grows as a crystallized product or an aggregated body by an intermolecular interaction thereof. Therefore, the pigment molecules sublimated from the inside of the coated film are crystallized and/or aggregated on the surface of the coated film, which may cause the generation of foreign substances. In a case where the foreign substances are generated on the surface of the coated film, light scattering occurs, and thus, it may be difficult to obtain the desired color phase.

In addition, even in a case where the foreign substances derived from the sublimation of the pigment are generated on the surface of the coated film, and thus, a content ratio of the pigment is changed from the surface to the inside of the coated film, it may be difficult to obtain the desired color phase. As described above, the generation of the foreign substances such as a crystallized product or an aggregated product due to the sublimation of the pigment on the surface of the coated film may cause the color unevenness of the pixel.

As the leveling agent suppressing the color unevenness of the pixel, in the related art, a leveling agent containing a fluorine atom is proposed (PTL 1).

### CITATION LIST

### PATENT LITERATURE

PTL 1: WO2017/145771

### SUMMARY OF INVENTION

### TECHNICAL PROBLEM

The leveling agent containing the fluorine atom has a high environmental burden, and thus, there is a demand for an alternative technology in response to the tightening of environmental regulation and a further increase in environmental awareness in recent years.

An object of the invention is to provide a silicone-containing copolymer that is capable of reducing an environmental burden and gives an effect of suppressing the generation of foreign substances due to the sublimation of a pigment on the surface of a coated film.

### SOLUTION TO PROBLEM

As a result of intensive studies of the present inventors in order to attain an object described above, it has been found that by a silicone-containing copolymer containing a polymerizable monomer (A) represented by a specific group, and a polymerizable monomer (B) having a group including a cyclic hydrocarbon skeleton, as at least a polymerization component, it is possible to obtain the silicone-containing copolymer that is capable of reducing an environmental burden and gives an effect of suppressing the generation of foreign substances due to the sublimation of a pigment on the surface of a coated film, and thus, the invention has been completed.

That is, the invention relates to a silicone-containing copolymer, containing: a polymerizable monomer (A) having a group represented by General Formula (a) described below; and a polymerizable monomer (B) having a group including a cyclic hydrocarbon skeleton, as at least a polymerization component. 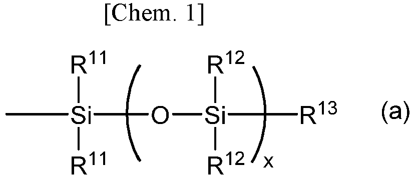 (In General Formula (a) described above,
R¹¹s are each independently an alkyl group having 1 to 6 carbon atoms or a group represented by -OSi(R¹⁴)₃ (R¹⁴s are each independently an alkyl group having 1 to 3 carbon atoms),
R¹²s are each independently an alkyl group having 1 to 6 carbon atoms,
R¹³ is an alkyl group having 1 to 6 carbon atoms, and
x is a number average value indicating the number of repetitions, and is an integer of 20 to 150.)

In addition, the invention relates to a leveling agent, containing the silicone copolymer described above.

In addition, the invention relates to a coating composition, containing the silicone copolymer described above.

In addition, the invention relates to a resist composition, containing: the silicone copolymer described above; and a colorant.

In addition, the invention relates to a color filter in which a coated film layer of the resist composition described above is formed on a substrate.

In addition, the invention relates to a method for producing a silicone-containing copolymer, including polymerizing a polymerizable monomer (A) having a group represented by General Formula (a) described below and a polymerizable monomer (B) having a group including a cyclic hydrocarbon skeleton. 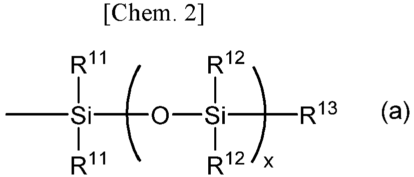 (In General Formula (a) described above,
R¹¹s are each independently an alkyl group having 1 to 6 carbon atoms or a group represented by -OSi(R¹⁴)₃ (R¹⁴s are each independently an alkyl group having 1 to 3 carbon atoms),
R¹²s are each independently an alkyl group having 1 to 6 carbon atoms,
R¹³ is an alkyl group having 1 to 6 carbon atoms, and
x is a number average value indicating the number of repetitions, and is an integer of 20 to 150.)

### ADVANTAGEOUS EFFECTS OF INVENTION

According to the invention, it is possible to provide the silicone-containing copolymer that is capable of reducing the environmental burden and gives the effect of suppressing the generation of the foreign substances due to the sublimation of the pigment on the surface of the coated film. In addition, it is possible to provide the leveling agent, the coating composition, the resist composition, and the color filter using the silicone-containing copolymer described above.

In addition, according to the invention, it is possible to provide the method for producing a silicone-containing copolymer described above.

### DESCRIPTION OF EMBODIMENTS

Hereinafter, one embodiment of the invention will be described. The invention is not limited to the following embodiment, and can be carried out by being suitably modified within a range not impairing the effects of the invention.

In the specification of this application, "(meth)acrylate" indicates one or both of acrylate and methacrylate.

### [Silicone-Containing Copolymer]

A silicone-containing copolymer of the invention (hereinafter, may be simply referred to as a "copolymer of the invention") is a copolymer containing a polymerizable monomer (A) having a group represented by General Formula (a) described below, and a polymerizable monomer (B) having a group including a cyclic hydrocarbon skeleton, as at least a polymerization component. 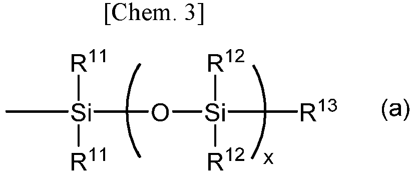 (In General Formula (a) described above,
R¹¹s are each independently an alkyl group having 1 to 6 carbon atoms or a group represented by -OSi(R¹⁴)₃ (R¹⁴s are each independently an alkyl group having 1 to 3 carbon atoms),
R¹²s are each independently an alkyl group having 1 to 6 carbon atoms,
R¹³ is an alkyl group having 1 to 6 carbon atoms, and
x is a number average value indicating the number of repetitions, and is an integer of 20 to 150.)

In the copolymer of the invention, by having the group including the bulky cyclic hydrocarbon skeleton, the copolymer becomes rigid. The group represented by General Formula (a) is segregated on the surface (the interface) of a coated film, and the copolymer has a rigid structure, and thus, it is possible to form a rigid (dense) thin film on the interface. It can be assumed that the sublimation of a colorant is physically blocked by the rigid thin film.

Note that in the invention, the "polymerizable monomer" indicates a compound having a polymerizable unsaturated group, and examples of the polymerizable unsaturated group in the polymerizable monomer (A) and the polymerizable monomer (B) include a C=C-containing group such as a (meth)acryloyl group, a (meth)acryloyl oxy group, a (meth)acryloyl amino group, a vinyl ether group, an allyl group, a styryl group, and a maleimide group. Among them, the (meth)acryloyl group and the (meth)acryloyl oxy group are preferable from the viewpoint of excellent availability of raw materials and excellent polymerization reactivity.

In addition, the number of polymerizable unsaturated groups in the polymerizable monomer may be 1, or may be 2 or more.

In the invention, the "polymerization component" indicates a component configuring a polymer, and does not contain a solvent, a polymerization initiator, and the like, which do not configure the polymer.

In General Formula (a) described above, R¹¹ is preferably a methyl group or a trimethyl siloxy group, and R¹² and R¹³ are preferably a methyl group.

In General Formula (a) described above, x is 20 to 150. It is assumed that by setting the lower limit of the number average value of x in the polymer of the invention to 20 or more, the copolymer of the invention is capable of exhibiting high surface tension reduction ability, and when the copolymer is used as a color resist composition or a coating composition, the copolymer is likely to be arranged in parallel on the surface (the interface) of the composition, and thus, the generation of the foreign substances from the inside of the coated film to the surface due to the sublimation of pigment molecules can be suppressed.

x is preferably in a range of 30 to 150, and more preferably in a range of 50 to 130.

Note that in the invention, the "number average value of x" indicates the average of the number of repeating units of a siloxane bond per one polymerizable monomer, for the polymerizable monomer (A) configuring the polymer of the invention.

The number average value of x in the polymer of the invention can be calculated from the number average molecular weight of the polymer of the invention.

The polymerizable monomer (A) is preferably a compound represented by General Formula (a-1) described below. 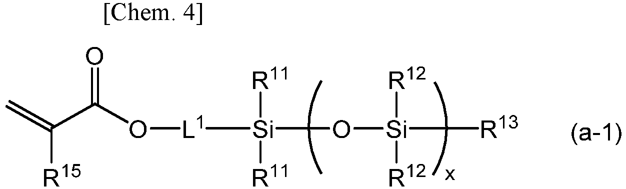 (In General Formula (a-1) described above,
R¹¹, R¹², R¹³, and x are identical to R¹¹, R¹², R¹³, and x in General Formula (a) described above, respectively,
R¹⁵ is a hydrogen atom or a methyl group, and
L¹ is a divalent organic group.)

The divalent organic group in L¹ is preferably a single bond, an alkylene group having 1 to 50 carbon atoms, or an alkylene oxy group having 1 to 50 carbon atoms.

Examples of the alkylene group having 1 to 50 carbon atoms in L¹ include a methylene group, an ethylene group, an n-propylene group, an n-butylene group, an n-pentylene group, an n-hexylene group, an n-heptylene group, an n-octylene group, an n-nonylene group, an n-decylene group, an n-dodecylene group, an isopropylene group, a 2-methyl propylene group, a 2-methyl hexylene group, and a tetramethyl ethylene group.

The alkylene group having 1 to 50 carbon atoms in L¹ is preferably an alkylene group having 1 to 15 carbon atoms, more preferably an alkylene group having carbon atoms 1 to 5, and even more preferably a methylene group, an ethylene group, an n-propylene group, or an isopropylene group.

The alkylene oxy group having 1 to 50 carbon atoms in L¹, for example, is a group in which one -CH₂- in the alkylene group is substituted with -O-.

The alkylene oxy group having 1 to 50 carbon atoms in L¹ is preferably an alkylene oxy group having 1 to 15 carbon atoms, more preferably an alkylene oxy group having 1 to 8 carbon atoms, and even more preferably a methylene oxy group, an ethylene oxy group, a propylene oxy group, an oxytrimethylene group, a butylene oxy group, an oxytetramethylene group, a pentylene oxy group, a heptylene oxy group, or an octylene oxy group.

In a case where the divalent organic group in L¹ is an alkylene group having 1 to 50 carbon atoms or an alkylene oxy group having 1 to 50 carbon atoms, in such divalent organic groups, a part of -CH₂- may be substituted with a carbonyl group (-C(=O)-), a phenylene group, an amide bond, or a urethane bond, or a carbon atom may be substituted with a hydroxyl group or the like.

The polymerizable monomer (A) can be produced by a known method, and a commercially available product may be used.

The polymerizable monomer (B) having the group including the cyclic hydrocarbon skeleton, which is the polymerization component of the silicone-containing copolymer of the invention, for example, has a function of making the copolymer rigid. **In** addition, the polymerizable monomer (B) has a function of guaranteeing compatibility.

The polymerizable monomer (B) may be a polymerizable monomer having a group including a cyclic hydrocarbon skeleton, and preferably contains a polymerizable monomer having a group including a cyclic hydrocarbon skeleton that has a bridged structure.

The polymerizable monomer (B) is preferably a compound represented by General Formula (b-1) described below. Such a compound is capable of giving the compatibility in a case where the copolymer of the invention is used as a leveling agent. 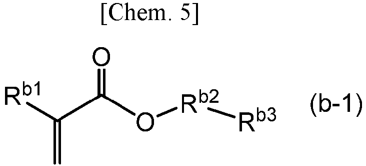 (In General Formula (b-1) described above,
R^{b1} is a hydrogen atom or an alkyl group having 1 to 6 carbon atoms,
R^{b2} is an alkylene group having 1 to 10 carbon atoms, an arylene group having 6 to 18 carbon atoms, or a divalent linking group consisting of two or more types of combinations selected from an alkylene group having 1 to 10 carbon atoms, an arylene group having 6 to 18 carbon atoms and an ether bond (-O-), and
R^{b3} is a group including a cyclic hydrocarbon skeleton.)

The alkylene group having 1 to 10 carbon atoms in R^{b2} may be linear, branched, or cyclic.

The arylene group having 6 to 18 carbon atoms in R^{b2} may be monocyclic, or may be condensed cyclic. Specific examples of the arylene group having 6 to 18 carbon atoms in R^{b2} include a phenylene group and a naphthylene group.

The alkylene group and the arylene group in R^{b2} may further have a substituent, and examples of the substituent include an alkyl group having 1 to 6 carbon atoms, a hydroxyl group, and a halogen atom.

In General Formula (b-1) described above, the group including the cyclic hydrocarbon skeleton in R^{b3} may be either a group including a cyclic hydrocarbon skeleton that has a bridged structure or a group including a cyclic hydrocarbon skeleton that does not has a bridged ring structure. Specific examples include a cyclohexane ring, an adamantane ring, a perhydroindene ring, a decalin ring, a perhydrofluorene ring, a perhydroanthracene ring, a perhydrophenanthrene ring, a dicyclopentane ring, a dicyclopentene ring, a perhydroacenaphthene ring, a perhydrophenalene ring, a norbornane ring, an isobornane ring, and a norbornene ring. Among them, the cyclohexane ring, the adamantane ring, the dicyclopentane ring, the norbornane ring, and the norbornene ring are preferable from the viewpoint of making it possible to suppress the generation of the foreign substances on the surface of the coated film due to the sublimation of the pigment.

Hereinafter, in the invention, a polymerizable monomer having an adamantane ring and a polymerizable unsaturated group that can be preferably used as the polymerizable monomer (b-1) will be described.

Examples of a polymerizable monomer having the adamantane ring and a (meth)acryloyl group include compounds represented by Formulae (b-1-1) and (b-1-2) described below. 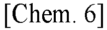 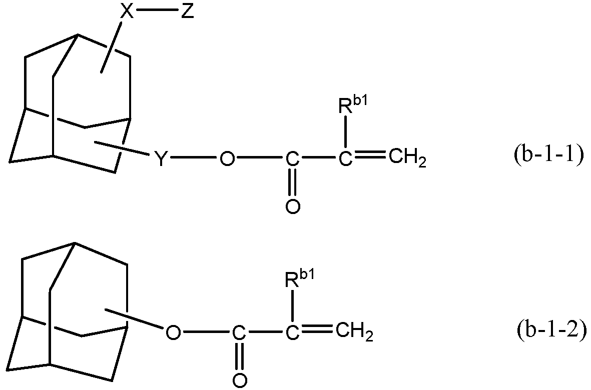 (In the formulae, Z represents a reactive functional group, X and Y represent a divalent organic group or a single bond, and R^{b1} represents a hydrogen atom or an alkyl group having 1 to 6 carbon atoms.)

Examples of the reactive functional group include a hydroxyl group, an isocyanate group, an epoxy group, a carboxyl group, a carboxylic acid halide group, and an anhydride group. Among them, the hydroxyl group is preferable from the viewpoint of obtaining a copolymer having excellent compatibility with a compounding component in the resist composition or the coating composition when the composition is produced by using the obtained copolymer.

The bonding position of the organic group having the reactive functional group represented by -X-Z in General Formula (b-1-1) described above and Y may be bonded to any carbon atom in the adamantane ring, and there may be two or more -X-Z. Further, X and Y in General Formula (b-1-1) described above are the divalent organic group or the single bond, and examples of the divalent organic group include an alkylene group having 1 to 8 carbon atoms, such as a methylene group, a propyl group, and an isopropylidene group.

In addition, in the compound represented by Formula (b-1-2) described above, the (meth)acryloyl group may be bonded to any carbon atom in the adamantane ring.

More specific examples of the polymerizable monomer represented by General Formula (b-1-1) described above include the following compounds.

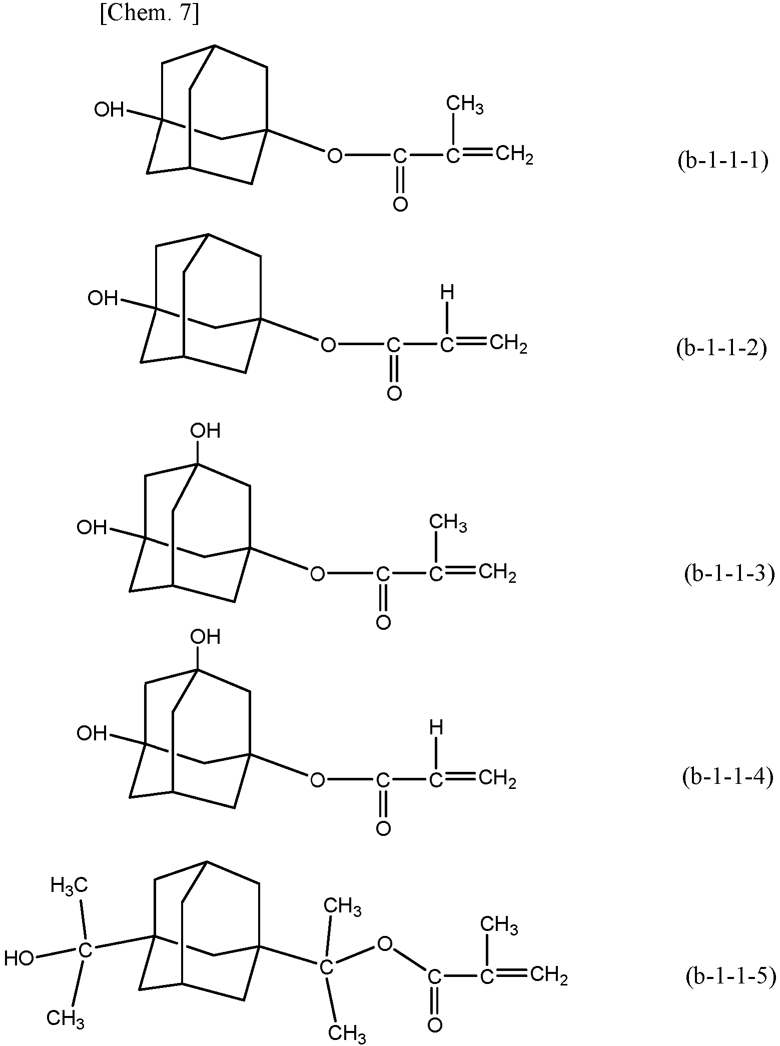

In addition, more specific examples of the polymerizable monomer represented by General Formula (b-1-2) include the following compounds.

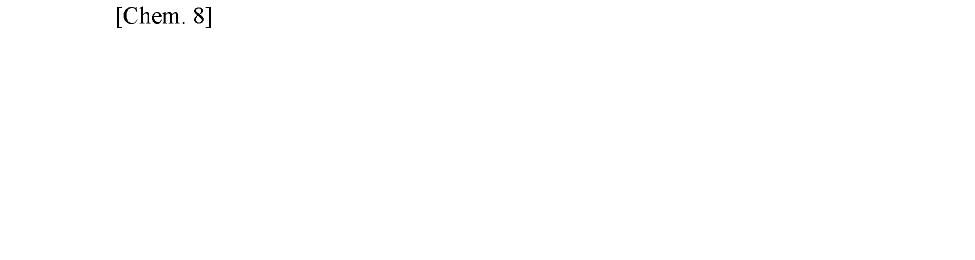

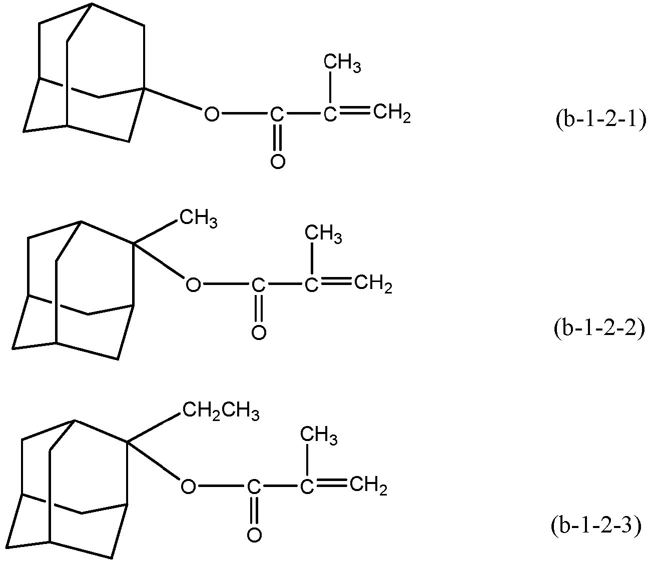

Among the polymerizable monomers having the adamantane ring and the (meth)acryloyl group, the compound represented by Formula (b-1-2) described above is preferable, and the compound represented by Formula (b-1-2-1) described above is more preferable, from the viewpoint of obtaining a random copolymer having excellent compatibility with the compounding component in the resist composition when the composition is produced by using the obtained copolymer.

Hereinafter, in the invention, a polymerizable monomer having a dicyclopentane ring and a polymerizable unsaturated group that can be preferably used as the polymerizable monomer (B) will be described.

Examples of a polymerizable monomer having the dicyclopentane ring and a (meth)acryloyl group include a compound represented by Formula (b-1-3) described below. 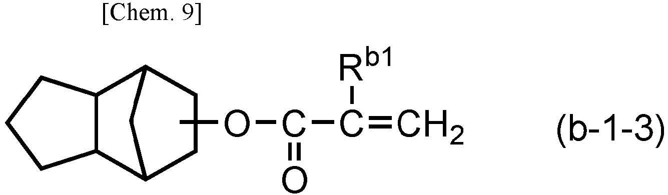 (In the formula, R^{b1} represents a hydrogen atom or an alkyl group having 1 to 6 carbon atoms.)

In addition, in the compound represented by Formula (b-1-3) described above, the (meth)acryloyl group may be bonded to any carbon atom in the dicyclopentane ring.

More specific examples of the polymerizable monomer represented by General Formula (b-1-3) described above include the following compounds.

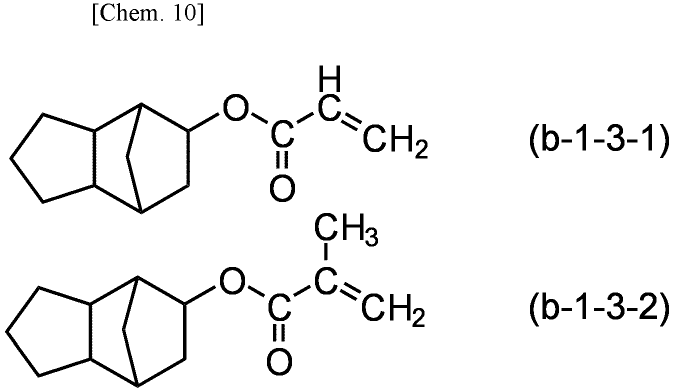

Among the polymerizable monomers having the dicyclopentane ring and the (meth)acryloyl group, the compound represented by Formula (b-1-3-2) described above is preferable from the viewpoint of obtaining a resist composition that is capable of suppressing the generation of the foreign substances due to the sublimation of the pigment.

Hereinafter, in the invention, a polymerizable monomer having a dicyclopentene ring and a polymerizable unsaturated group that can be preferably used as the polymerizable monomer (b-1) will be described.

Examples of a polymerizable monomer having the dicyclopentene ring and a (meth)acryloyl group include a compound represented by Formula (b-1-4) described below. 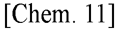 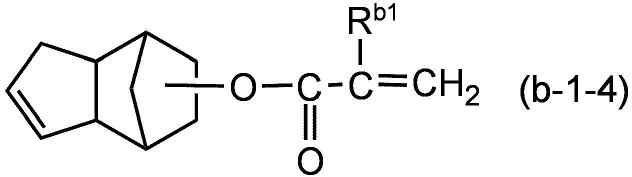 (In the formula, R^{b1} represents a hydrogen atom or an alkyl group having 1 to 6 carbon atoms.)

In addition, in the compound represented by Formula (b-1-4) described above, the (meth)acryloyl group may be bonded to any carbon atom in the dicyclopentene ring.

More specific examples of the polymerizable monomer represented by General Formula (b-1-4) described above include the following compounds.

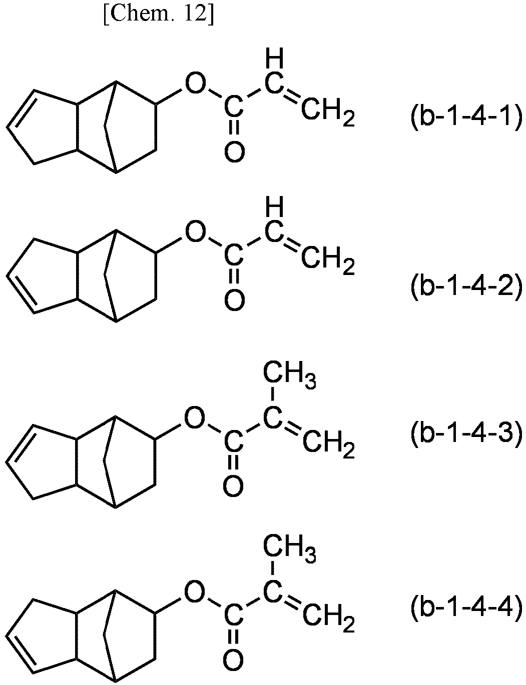

Among the polymerizable monomers having the dicyclopentene ring and the (meth)acryloyl group, the compound represented by Formula (b-1-4-2) described above is preferable from the viewpoint of obtaining the resist composition that is capable of suppressing the generation of the foreign substances due to the sublimation of the pigment.

Hereinafter, in the invention, a polymerizable monomer having a norbornane ring and a polymerizable unsaturated group that can be preferably used as the polymerizable monomer (b-1) will be described.

Examples of a polymerizable monomer having the norbornane ring and a (meth)acryloyl group include a compound represented by Formula (b-1-5) described below. 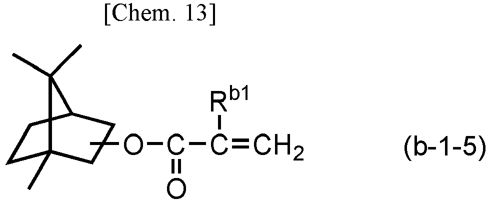 (In the formula, R^{b1} represents a hydrogen atom or an alkyl group having 1 to 6 carbon atoms.)

In addition, in the compound represented by Formula (b-1-5) described above, the (meth)acryloyl group may be bonded to any carbon atom in the norbornane ring.

More specific examples of the polymerizable monomer represented by General Formula (b-1-5) described above include the following compounds.

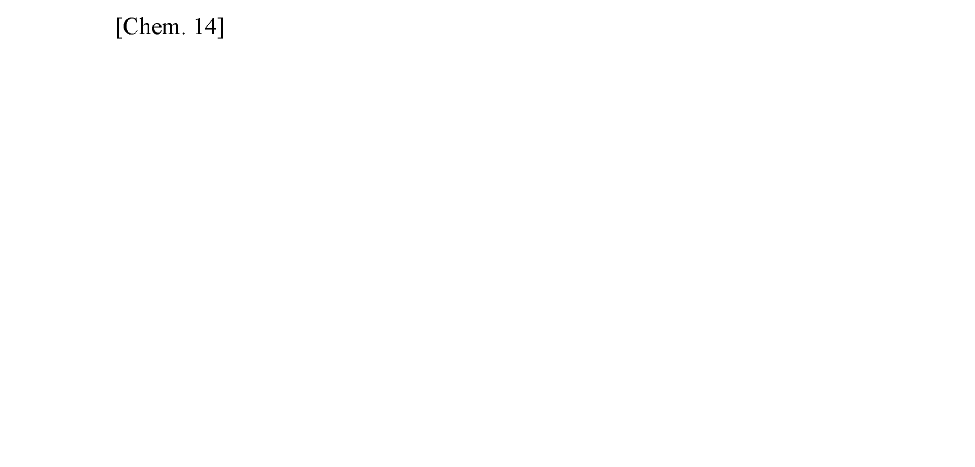

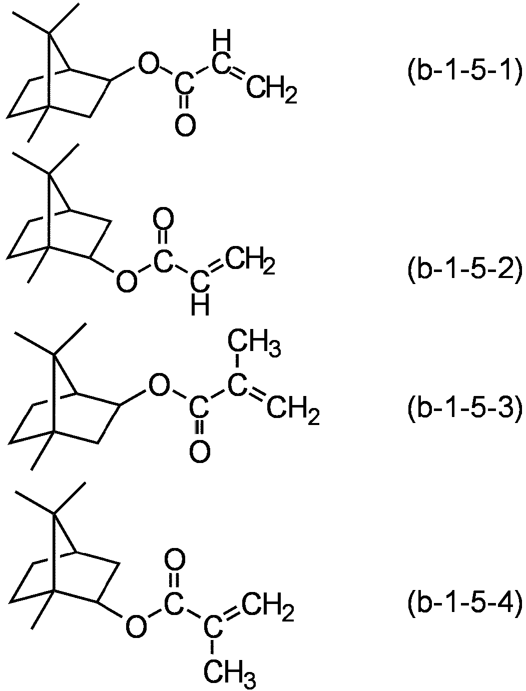

Among the polymerizable monomers having the norbornane ring and the (meth)acryloyl group, the compound represented by Formula (b-1-5-2) described above is preferable from the viewpoint of obtaining the resist composition that is capable of suppressing the generation of the foreign substances due to the sublimation of the pigment.

Hereinafter, in the invention, a polymerizable monomer having a norbornene ring and a polymerizable unsaturated group that can be preferably used as the polymerizable monomer (b-1) will be described.

Examples of a polymerizable monomer having the norbornene ring and a (meth)acryloyl group include a compound represented by Formula (b-1-6) described below. 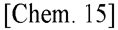 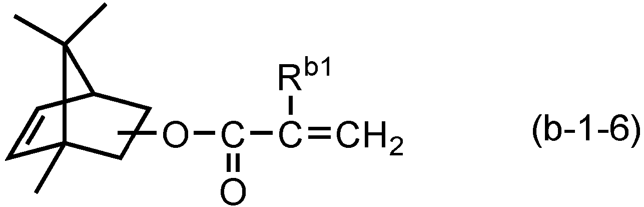 (In the formula, R^{b1} represents a hydrogen atom or an alkyl group having 1 to 6 carbon atoms.)

In addition, in the compound represented by Formula (b-1-6) described above, the (meth)acryloyl group may be bonded to any carbon atom in the norbornene ring.

More specific examples of the polymerizable monomer represented by General Formula (b-1-6) described above include the following compounds.

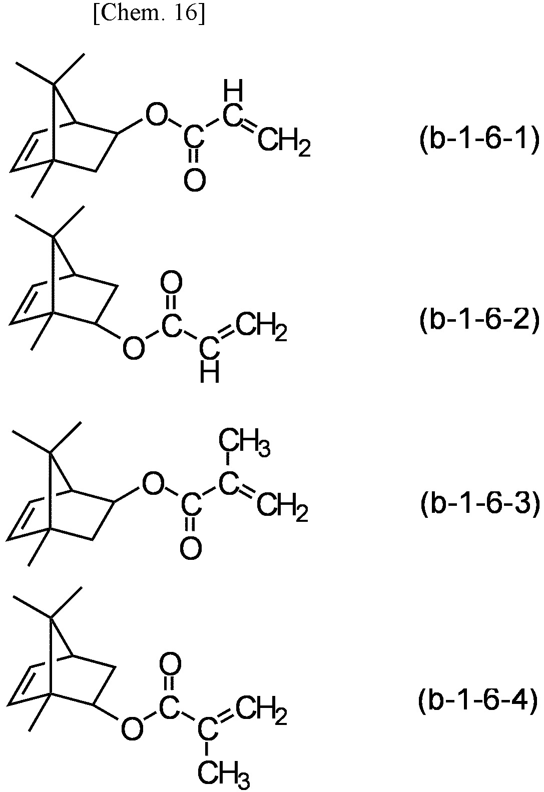

Among the polymerizable monomers having the norbornene ring and the (meth)acryloyl group, the compound represented by Formula (b-1-6-2) described above is preferable from the viewpoint of obtaining the resist composition that is capable of suppressing the generation of the foreign substances due to the sublimation of the pigment.

The polymerizable monomer (B) can be produced by a known method.

In addition, as the polymerizable monomer (B), a commercially available product may be used.

There may be only one type or two or more types of the polymerizable monomers (B) configuring the silicone-containing copolymer of the invention.

The polymerization type of the silicone-containing copolymer that is the copolymer containing the polymerizable monomer (A) and the polymerizable monomer (B) as at least the polymerization component is not particularly limited, and may be a random copolymer of the polymerizable monomer (A) and the polymerizable monomer (B), or may be a block copolymer of the polymerizable monomer (A) and the polymerizable monomer (B).

A mass ratio of the polymerizable monomer (A) to the polymerizable monomer (B) in the silicone-containing copolymer, for example, is Polymerizable Monomer (A) : Polymerizable Monomer (B) = 5 : 95 to 95 : 5, preferably Polymerizable Monomer (A) : Polymerizable Monomer (B) = 5 : 95 to 80 : 20, more preferably Polymerizable Monomer (A) : Polymerizable Monomer (B) = 5 : 95 to 60 : 40, even more preferably 5 : 95 to 50 : 50, and particularly preferably Polymerizable Monomer (A) : Polymerizable Monomer (B) = 5 : 95 to 30 : 70.

The silicone-containing copolymer of the invention may include a constitutional unit of a polymerizable monomer other than the polymerizable monomer (A) and the polymerizable monomer (B) within a range not impairing the effects of the invention, insofar as the silicone-containing copolymer is a copolymer of the polymerizable monomer (A) and the polymerizable monomer (B).

The copolymer of the invention is preferably a copolymer substantially consisting of the polymerizable monomer (A) and the polymerizable monomer (B), and more preferably a copolymer consisting only of the polymerizable monomer (A) and the polymerizable monomer (B). Here, "substantially consisting of" indicates a case where the total content ratio of the polymerizable monomer (A) and the polymerizable monomer (B) in the copolymer of the invention is 80% by mass or more, 90% by mass or more, 95% by mass or more, or 99% by mass or more.

It is preferable that the silicone-containing copolymer of the invention does not contain the fluorine atom. By the silicone-containing copolymer of the invention not containing the fluorine atom, it is possible to increase solvent resistance. In addition, by the silicone-containing copolymer of the invention being a fluorine atom-free resin, it is possible to decrease an accumulative property with respect to the environment, and reduce an environmental burden.

The weight average molecular weight (Mw) of the silicone-containing copolymer of the invention is preferably in a range of 3000 to 80000, and more preferably in a range of 4000 to 50000.

The weight average molecular weight of the silicone-containing copolymer of the invention is measured by a method described in Examples.

A ratio of a structure derived from the polymerizable monomer (A) in the silicone-containing copolymer of the invention, for example, is in a range of 5 to 80% by mass, preferably in a range of 5 to 60% by mass, and more preferably in a range of 5 to 50% by mass.

The ratio of the structure derived from the polymerizable monomer (A) in the silicone-containing copolymer of the invention is a value calculated from a mass ratio of the polymerizable monomer (A) to the total amount of the raw materials used.

A content rate of the silicone chain represented by General Formula (a) described above in the silicone-containing copolymer of the invention is preferably in a range of 5 to 80% by mass, more preferably in a range of 5 to 60% by mass, and even more preferably in a range of 5 to 50% by mass.

The content rate of the silicone chain in the silicone-containing copolymer of the invention is a value calculated from a mass ratio of the silicone chain to the total amount of the raw materials used.

### [Method for Producing Silicone-Containing Copolymer]

A method for producing the copolymer of the invention is not particularly limited, and can be produced by a known method.

The copolymer of the invention can be produced by performing a solution polymerization method, a bulk polymerization method, an emulsion polymerization method, or the like on the polymerization component, on the basis of a polymerization mechanism such as a radical polymerization method, a cationic polymerization method, and an anionic polymerization method. For example, in the radical polymerization method, the polymerization component is prepared in an organic solvent, and a general-purpose radical polymerization initiator is added, and thus, the copolymer of the invention can be produced.

The copolymer obtained as described above is a random copolymer.

As the polymerization initiator, various polymerization initiators can be used, and examples thereof include a peroxide such as acetyl peroxide, diacyl peroxide, cumyl peroxide, t-butyl peroxide, propionyl peroxide, benzoyl peroxide, 2-chlorobenzoyl peroxide, 3-chlorobenzoyl peroxide, 4-chlorobenzoyl peroxide, 2,4-dichlorobenzoyl peroxide, 4-bromomethyl benzoyl peroxide, lauroyl peroxide, diisopropyl peroxycarbonate, tetralin hydroperoxide, t-butyl peroxy-2-ethyl hexanoate, 1-phenyl-2-methyl propyl-1-hydroperoxide, t-butyl triphenyl peracetate, t-butyl hydroperoxide, t-butyl performate, t-butyl peracetate, t-butyl perbenzoate, t-butyl 2-ethyl perhexanoate, t-butyl phenyl peracetate, and t-butyl 4-methoxyperacetate; an azo compound such as 2,2'-dichloro-2,2'-azobispropane, 1,1'-azo(methyl ethyl) diacetate, 2,2'-azobis(2-amidinopropane) nitrate, 2,2'-azobisisobutane, 2,2'-azobisisobutyl amide, 2,2'-azobisisobutyronitrile, methyl 2,2'-azobis-2-methyl propionate, 2,2'-dichloro-2,2'-azobisbutane, 2,2'-azobis-2-methyl butyronitrile, dimethyl 2,2'-azobisisobutyrate, dimethyl 2,2'-azobisisobutyrate, 2-(4-methyl phenyl azo)-2-methyl malonodinitrile, 4,4'-azobis-4-cyanovalerate, 3,5-dihydroxymethyl phenyl azo-2-methyl malonodinitrile, 1,1'-azobis-1-cyclohexane carbonitrile, 1,1'-azobis-1-phenyl ethane, 1,1'-azobiscumene, ethyl 4-nitrophenyl azobenzyl cyanoacetate, phenyl azodiphenyl methane, phenyl azotriphenyl methane, 4-nitrotriphenyl azotriphenyl methane, and 1,1'-azobis-1,2-diphenyl ethane, an azo compound such as azobisisobutyronitrile, azobisisobutyrate dimethyl, and phenyl azotriphenyl methane, and a metal chelate compound such as Mn(acac)₃.

As necessary, a chain transfer agent such as lauryl mercaptane, thioglycerol, 2-mercaptoethanol, ethyl thioglycolate, and octyl thioglycolate, or a thiol compound having a coupling group such as γ-mercaptopropyl trimethoxysilane may be used as an additive such as a chain transfer agent.

As the organic solvent, ketones, esters, amides, sulfoxides, ethers, hydrocarbons, a fluorine-based solvent, and the like are preferable, and specifically, examples thereof include alcohols such as ethanol, isopropyl alcohol, n-butanol, iso-butanol, and tert-butanol, ketones such as acetone, methyl ethyl ketone, methyl isobutyl ketone, cyclohexanone, and methyl amyl ketone, esters such as methyl acetate, ethyl acetate, butyl acetate, methyl lactate, ethyl lactate, and butyl lactate, monocarboxylic esters such as methyl 2-oxypropionate, ethyl 2-oxypropionate, propyl 2-oxypropionate, butyl 2-oxypropionate, methyl 2-methoxypropionate, ethyl 2-methoxypropionate, propyl 2-methoxypropionate, and butyl 2-methoxypropionate, a polar solvent such as dimethyl formamide, dimethyl sulfoxide, dimethyl acetamide, and N-methyl pyrrolidone, ethers such as diethyl ether, diisopropyl ether, methyl cellosolve, cellosolve, butyl cellosolve, butyl carbitol, and ethyl cellosolve acetate, propylene glycols such as propylene glycol, propylene glycol monomethyl ether, propylene glycol monomethyl ether acetate, propylene glycol monoethyl ether acetate, and propylene glycol monobutyl ether acetate, and esters thereof, a halogen-based solvent such as 1,1, 1-trichloroethane and chloroform, ethers such as tetrahydrofuran and dioxane, aromatics such as benzene, toluene, and xylene, a fluorine-based solvent such as 1,3-bis(trifluoromethyl) benzene and 1,4-bis(trifluoromethyl) benzene, and fluorinated inert liquids such as perfluorooctane and perfluorotri-n-butyl amine.

Such organic solvents are suitably selected in consideration of a boiling point, compatibility with a raw material or a polymer, and polymerizability. The polymerizable monomer (A) is particularly excellent in compatibility with an organic solvent, and thus, can be almost dissolved in the organic solvent described above.

Only one type of such solvents can be used, or two or more types thereof can be used together.

In the copolymer of the invention, preferably, the addition of the polymerizable monomer (A) to a reaction system is started, the polymerizable monomer (B) and the polymerization initiator are added to the reaction system to start polymerization after the addition of the polymerizable monomer (A) is started, and the addition of the polymerizable monomer (A) is ended before the addition of the polymerizable monomer (B) and the polymerization initiator is ended.

This is because by polymerizing the polymer of the invention as described above, it is possible to infinitely decrease the unreacted silicone chain, and thus, it is possible to suppress the defect of the coated film that is a concern due to the additive during coating.

The polymerizable monomer (A) may contain impurities of a compound having a cyclic siloxane structure, and the compound having the cyclic siloxane structure may be removed by distilling the polymerizable monomer (A) before being added to the reaction system or distilling the polymer after the reaction. The distillation can be carried out by a known method, and for example, can be carried out by thin film distillation.

The polymer of the invention can also be produced by performing living polymerization, such as living radical polymerization and living anionic polymerization, on the polymerization component.

In the living radical polymerization, a dormant species in which an active polymerization end is protected by an atom or an atom group reversibly generates radicals to cause a reaction with a monomer such that a propagation reaction progresses, and even in a case where a first monomer is consumed, a propagation end does not lose the activity to cause a reaction with a second monomer to be sequentially added, and thus, a block polymer can be obtained. Examples of such living radical polymerization include atom transfer radical polymerization (ATRP), reversible addition-fragmentation radical polymerization (RAFT), nitroxide-mediated radical polymerization (NMP), and organotellurium-mediated radical polymerization (TERP). Among them, which method to be used is not particularly restricted, but ATRP is preferable from the viewpoint of easy control. In ATRP, polymerization is performed by using an organic halide, a sulfonyl halide compound, or the like as a polymerization initiator, and using a metal complex containing a transition metal compound and a ligand as a catalyst.

Specific examples of the polymerization initiator that can be used in ATRP include 1-phenyl ethyl chloride, 1-phenyl ethyl bromide, chloroform, carbon tetrachloride, 2-chloropropionitrile, α,α'-dichloroxylene, α,α'-dibromoxylene, hexakis(α-bromomethyl) benzene, and alkyl ester having 1 to 6 carbon atoms of 2-halogenated carboxylate having 1 to 6 carbon atoms (for example, 2-chloropropionate, 2-bromopropionate, 2-chloroisobutyrate, 2-bromoisobutyrate, and the like).

More specific examples of the alkyl ester having 1 to 6 carbon atoms of the 2-halogenated carboxylate having 1 to 6 carbon atoms include methyl 2-chloropropionate, ethyl 2-chloropropionate, methyl 2-bromopropionate, and ethyl 2-bromoisobutyrate.

The transition metal compound that can be used in ATRP is represented by Mⁿ⁺xₙ.

A transition metal Mⁿ⁺ in the transition metal compound represented by Mⁿ⁺Xₙ can be selected from the group consisting of Cu⁺, Cu²⁺, Fe²⁺, Fe³⁺, Ru²⁺, Ru³⁺, Cr²⁺, Cr³⁺, Mo⁰, Mo⁺ , Mo²⁺ , Mo³⁺ , W²⁺ , W³⁺, Rh³⁺ , Rh⁴⁺ , Co⁺ , Co²⁺ , Re²⁺ , Re³⁺ , Ni^{o} , Ni⁺ , Mn³⁺ , Mn⁴⁺ , V²⁺, V³⁺, Zn⁺, Zn²⁺, Au⁺, Au²⁺, Ag⁺, and Ag²⁺.

X in the transition metal compound represented by Mⁿ⁺Xₙ can be selected from the group consisting of a halogen atom, an alkoxyl group having 1 to 6 carbon atoms, (SO₄)_{1/2}, (PO₄)_{1/3}, (HPO₄)_{1/2}, (H₂PO₄), triflate, hexafluorophosphate, methane sulfonate, aryl sulfonate (preferably, benzene sulfonate or toluene sulfonate), SeR¹¹, CN, and R¹²COO. Here, R¹¹ represents an aryl group or a linear or branched alkyl group having 1 to 20 carbon atoms (preferably 1 to 10 carbon atoms), and R¹² represents a hydrogen atom or a linear or branched alkyl group having 1 to 6 carbon atoms (preferably a methyl group) that may be substituted with halogen 1 to 5 times (preferably with fluorine or chlorine 1 to 3 times).

n in the transition metal compound represented by Mⁿ⁺Xₙ represents a formal charge on a metal, and is an integer of 0 to 7.

Examples of a ligand compound that can be coordination-bonded to the transition metal of the transition metal compound include a compound having a ligand containing one or more nitrogen atoms, oxygen atoms, phosphorus atoms, or sulfur atoms that can be coordinated to the transition metal through an σ bond, a compound having a ligand containing two or more carbon atoms that can be coordinated to the transition metal through a π bond, and a compound having a ligand that can be coordinated to the transition metal through a µ bond or a η bond.

The transition metal complex is not particularly limited, and preferred examples thereof include transition metal complexes in Groups 7, 8, 9, 10, and 11, and more preferred examples thereof include a complex of zero-valent copper, monovalent copper, divalent ruthenium, divalent iron, or divalent nickel.

Specific examples of the catalyst that can be used in ATRP in a case where the central metal is copper include a complex with a ligand such as 2,2'-bipyridyl and a derivative thereof, 1,10-phenanthroline and a derivative thereof, and polyamine such as tetramethyl ethylene diamine, pentamethyl diethylene triamine, and hexamethyl tris(2-aminoethyl) amine. In addition, examples of the divalent ruthenium complex include dichlorotris(triphenyl phosphine) ruthenium, dichlorotris(tributyl phosphine) ruthenium, dichloro(cyclooctadiene) ruthenium, dichlorobenzene ruthenium, dichlorop-cymene ruthenium, dichloro(norbornadiene) ruthenium, cis-dichlorobis(2,2'-bipyridine) ruthenium, dichlorotris(1,10-phenanthroline) ruthenium, and carbonyl chlorohydridotris(triphenyl phosphine) ruthenium. Further, examples of the divalent iron complex include a bistriphenyl phosphine complex and a triazacyclononane complex.

In a case where the polymer of the invention is produced by living polymerization, the polymerizable monomer (A) itself can be used as a polymerization initiator. The polymerizable monomer (A) which can be used as the polymerization initiator is a compound represented by General Formula (a-2) described below. 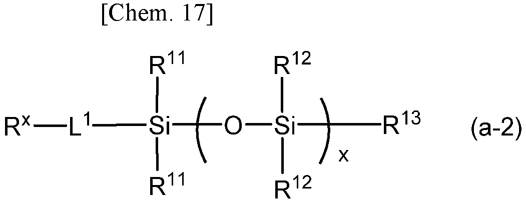 (In Formula (a-2) described above,
R¹¹, R¹², R¹³, L¹, and x are identical to R¹¹, R¹², R¹³, L¹, and x in General Formula (a-1) described above, and
R^{X} is a functional group having radical generation ability.)

In Formula (a-2) described above, the functional group having the radical generation ability of R^{X}, for example, is a functional group having a halogen atom, and preferably a functional group represented by Formula (X-1) described below. 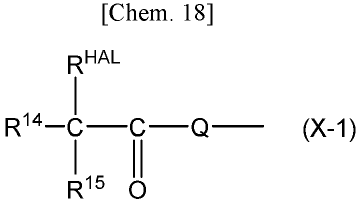 (In Formula (X-1) described above,
R^{HAL} is a halogen atom,
R¹⁴ and R¹⁵ are each independently an alkyl group having 1 to 6 carbon atoms, and
Q is an oxygen atom or a sulfur atom.)

In the living radical polymerization, it is preferable to use a solvent.

Examples of the solvent that can be used in the living radical polymerization include an ester-based solvent such as ethyl acetate, butyl acetate, and propylene glycol monomethyl ether acetate; an ether-based solvent such as diisopropyl ether, dimethoxyethane, and diethylene glycol dimethyl ether; a halogen-based solvent such as dichloromethane and dichloroethane; an aromatic solvent such as toluene and xylene; a ketone-based solvent such as methyl ethyl ketone, methyl isobutyl ketone, and cyclohexanone; an alcohol-based solvent such as methanol, ethanol, and isopropanol; and an aprotic polar solvent such as dimethyl formamide and dimethyl sulfoxide.

Only one type of the solvents may be used, or two or more types thereof may be used together.

In a case where the polymer of the invention is produced by living polymerization, for example, the polymer can be produced by any of Methods 1 to 3 described below.

Method 1: a method for living-radical-polymerizing (preferably atom-transfer-radical-polymerizing) the polymerizable monomer (A) and the polymerizable monomer (B), in the presence of the polymerization initiator, the transition metal compound, the ligand compound that can be coordination-bonded to the transition metal, and the solvent.

Method 2: a method for living-radical-polymerizing (preferably atom-transfer-radical-polymerizing) the polymerizable monomer (A) to obtain a polymer block of the polymerizable monomer (A), and then, adding the polymerizable monomer (B) to the reaction system to further living-radical-polymerize (preferably atom-transfer-radical-polymerize) the polymerizable monomer (B) on the polymer block of the polymerizable monomer (A), in the presence of the polymerization initiator, the transition metal compound, the ligand compound that can be coordination-bonded to the transition metal, and the solvent.

Method 3: a method for living-radical-polymerizing (preferably atom-transfer-radical-polymerizing) the polymerizable monomer (B) to obtain a polymer block of the polymerizable monomer (B), and then, adding the polymerizable monomer (A) to the reaction system to further living-radical-polymerize (preferably atom-transfer-radical-polymerize) the polymerizable monomer (A) on the polymer block of the polymerizable monomer (B), in the presence of the polymerization initiator, the transition metal compound, the ligand compound that can be coordination-bonded to the transition metal, and the solvent.

As a polymerization temperature during the living radical polymerization, a range from a room temperature to 120°C is preferable.

In a case where the polymer of the invention is produced by the living radical polymerization, a metal due to the transition metal compound used in the polymerization may remain in the obtained polymer. The metal remaining in the obtained polymer may be removed by using active alumina or the like after the polymerization is ended.

### [Coating Composition]

The polymer of the invention can be preferably used as the leveling agent of the coating composition, and a coating composition of the invention contains the polymer of the invention. The polymer of the invention can be a fluorine atom-free leveling agent not containing a fluorine atom, and thus, is a leveling agent with a low accumulative property with respect to the environment and a reduced environmental burden.

The content of the copolymer of the invention in the coating composition of the invention is different in accordance with the type of base resin, a coating method, a desired film thickness, or the like, and is preferably 0.0001 to 10 parts by mass, more preferably 0.001 to 5 parts by mass, and even more preferably 0.01 to 2 parts by mass, with respect to 100 parts by mass of the solid content (for example, the base resin) of the coating composition. In a case where the content of the copolymer of the invention is in the range described above, it is possible to sufficiently decrease a surface tension, obtain a desired leveling property, and suppress the occurrence of a problem such as foaming during coating.

The application of the coating composition of the invention is not particularly limited, and the coating composition can be used in any application insofar as the application is one in which the leveling property is requested. The coating composition of the invention, for example, can be used as various coating material compositions or photosensitive resin compositions.

In a case where the coating composition of the invention is a composition for a coating material, examples of the composition for a coating material include a coating material using a natural resin, such as a petroleum resin coating material, a shellac coating material, a rosin-based coating material, a cellulose-based coating material, a rubber-based coating material, a lacquer coating material, a cashew resin coating material, and an oil-based vehicle coating material; and a coating material using a synthetic resin, such as a phenol resin coating material, an alkyd resin coating material, an unsaturated polyester resin coating material, an amino resin coating material, an epoxy resin coating material, a vinyl resin coating material, an acrylic resin coating material, a polyurethane resin coating material, and a silicone resin coating material.

By adding the polymer of the invention to the composition for a coating material described above, it is possible to impart smoothness to the coated film to be obtained.

In the composition for a coating material, as necessary, a colorant such as a pigment, a dye, and carbon; an inorganic powder such as silica, titanium oxide, zinc oxide, aluminum oxide, zirconium oxide, calcium oxide, and calcium carbonate; an organic fine powder such as a higher fatty acid, a polyacrylic resin, and polyethylene; and various additives such as a light resistance improver, a weather resistance improver, a heat resistance improver, an antioxidant, a thickener, and an antisettling agent can be suitably added.

As a coating method of the coating composition of the invention, any method can be used insofar as the method is a publicly known and available coating method, and examples thereof include methods such as a slit coater, a slit & spin coater, a spin coater, a roll coater, electrostatic coating, a bar coater, a gravure coater, a die coater, a knife coater, inkjet, dipping application, spray application, shower coating, screen printing, gravure printing, offset printing, and reverse coating.

The photosensitive resin composition changes the physical property of the resin, such as solubility, viscosity, transparency, a refractive index, conductivity, and ion permeability, by the irradiation of light such as visible light and ultraviolet light.

**In** the photosensitive resin composition, the resist composition (a photoresist composition, a color resist composition for a color filter, or the like) is required to have a high leveling property. **In** general, the resist composition is applied by spin coating onto a silicon wafer or a glass substrate on which various metals are vapor-deposited such that a thickness is approximately 1 to 2 µm. In this case, when the applied film thickness fluctuates or application unevenness occurs, there is a problem that the linearity and the reproducibility of a pattern decrease, and a resist pattern with a desired accuracy is not obtained. **In** addition, in addition to such a problem, there are various problems relevant to leveling, such as drip mark, overall unevenness, and a bead phenomenon in which the film thickness in the edge portion is greater than the film thickness in the central portion.

Since the polymer of the invention exhibits a high leveling property, and thus, is capable of forming an even coated film (cured product), the coating composition of the invention is capable of solving the problems as described above when used as the resist composition.

In a case where the coating composition of the invention is a photoresist composition, the photoresist composition contains an alkali-soluble resin, a radiation-sensitive substance (a photosensitive substance), a solvent, and the like, in addition to the polymer of the invention.

The alkali-soluble resin in the photoresist composition is a resin soluble in an alkaline solution that is a developer used in resist patterning.

Examples of the alkali-soluble resin include a novolak resin obtained by condensing an aromatic hydroxy compound derivative, such as phenol, cresol, xylenol, resorcinol, phloroglucinol, and hydroquinone, and an aldehyde compound, such as formaldehyde, acetaldehyde, and benzaldehyde; a polymer or a copolymer of a vinyl phenol compound derivative, such as o-vinyl phenol, m-vinyl phenol, p-vinyl phenol, and α-methyl vinyl phenol; a (meth)acrylic acid-based polymer or copolymer, such as an acrylic acid, a methacrylic acid, and hydroxyethyl (meth)acrylate; polyvinyl alcohol; a modified resin in which a radiation-sensitive group, such as a quinone diazide group, a naphthoquinone azide group, an aromatic azide group, and an aromatic cinnamoyl group, is introduced through a part of hydroxyl groups in such various resins; and a urethane resin having an acidic group such as a carboxylic acid and a sulfonic acid in the molecules.

Only one type of such alkali-soluble resins may be used, or two or more types thereof can be used together.

The radiation-sensitive substance in the photoresist composition is a substance that changes the solubility of the alkali-soluble resin to the developer by the irradiation of an energy ray, such as an ultraviolet ray, a far-ultraviolet ray, excimer laser light, an X-ray, electron beam, an ionic ray, a molecular ray, and a γ-ray.

Examples of the radiation-sensitive substance include a quinone diazide-based compound, a diazo-based compound, an azide-based compound, an onium salt compound, a halogenated organic compound, a mixture of a halogenated organic compound and an organic metal compound, an organic acid ester compound, an organic acid amide compound, an organic acid imide compound, and a poly(olefin sulfone) compound.

Examples of the quinone diazide-based compound include 1,2-benzoquinone azide-4-sulfonic acid ester, 1,2-naphthoquinone diazide-4-sulfonic acid ester, 1,2-naphthoquinone diazide-5-sulfonic acid ester, 2,1-naphthoquinone diazide-4-sulfonic acid ester, 2,1-naphthoquinone diazide-5-sulfonic acid ester, and sulfonic acid chloride of a quinone diazide derivative, such as 1,2-benzoquinone azide-4-sulfonic acid chloride, 1,2-naphthoquinone diazide-4-sulfonic acid chloride, 1,2-naphthoquinone diazide-5-sulfonic acid chloride, 2,1-naphthoquinone diazide-4-sulfonic acid chloride, and 2,1-naphthoquinone diazide-5-sulfonic acid chloride.

Examples of the diazo-based compound include a salt of a condensate of p-diazodiphenyl amine and formaldehyde or acetaldehyde, a diazo resin inorganic salt that is a reaction product of hexafluorophosphate, tetrafluoroborate, perchlorate, or periodate, and the condensate described above, and a diazo resin organic salt that is a reaction product of the condensate described above and sulfonic acids, as described in the specification of USP3,300,309.

Examples of the azide-based compound include an azidochalconic acid, diazide benzal methyl cyclohexanones, azide cinnamylidene acetophenones, an aromatic azide compound, and an aromatic diazide compound.

Examples of the halogenated organic compound include a halogen-containing oxadiazole-based compound, a halogen-containing triazine-based compound, a halogen-containing acetophenone-based compound, a halogen-containing benzophenone-based compound, a halogen-containing sulfoxide-based compound, a halogen-containing sulfonebased compound, a halogen-containing thiazole-based compound, a halogen-containing oxazole-based compound, a halogen-containing trizole-based compound, a halogen-containing 2-pyrone-based compound, a halogen-containing aliphatic hydrocarbon-based compound, a halogen-containing aromatic hydrocarbon-based compound, a halogen-containing heterocyclic compound, and a sulfenyl halide-based compound.

In addition, a compound that is used as a halogen-based flame retarder, such as tris(2,3-dibromopropyl) phosphate, tris(2,3-dibromo-3-chloropropyl) phosphate, chlorotetrabromomethane, hexachlorobenzene, hexabromobenzene, hexabromocyclododecane, hexabromobiphenyl, tribromophenyl allyl ether, tetrachlorobisphenol A, tetrabromobisphenol A, bis(bromoethyl ether) tetrabromobisphenol A, bis(chloroethyl ether) tetrachlorobisphenol A, tris(2,3-dibromopropyl) isocyanurate, 2,2-bis(4-hydroxy-3,5-dibromophenyl) propane, and 2,2-bis(4-hydroxyethoxy-3,5-dibromophenyl) propane, a compound that is used as an organic chlorine-based pesticide, such as dichlorophenyl trichloroethane, and the like are also exemplified as the halogenated organic compound.

Examples of the organic acid ester include carboxylic acid ester and sulfonic acid ester. In addition, examples of the organic acid amide include carboxylic acid amide and sulfonic acid amide. Further, examples of the organic acid imide include carboxylic acid imide and sulfonic acid imide.

Only one type of the radiation-sensitive substances may be used, or two or more types thereof can be used together.

In the photoresist composition, the content of the radiation-sensitive substance is preferably in a range of 10 to 200 parts by mass, and more preferably in a range of 50 to 150 parts by mass, with respect to 100 parts by mass of the alkali-soluble resin.

Examples of the solvent for the photoresist composition include ketones such as acetone, methyl ethyl ketone, cyclohexanone, cyclopentanone, cycloheptanone, 2-heptanone, methyl isobutyl ketone, and butyrolactone; alcohols such as methanol, ethanol, n-propyl alcohol, iso-propyl alcohol, n-butyl alcohol, iso-butyl alcohol, tert-butyl alcohol, pentanol, heptanol, octanol, nonanol, and decanol; ethers such as ethylene glycol dimethyl ether, ethylene glycol diethyl ether, and dioxane; alcohol ethers such as ethylene glycol monomethyl ether, ethylene glycol monoethyl ether, ethylene glycol monopropyl ether, propylene glycol monomethyl ether, propylene glycol monoethyl ether, and propylene glycol monopropyl ether; esters such as ethyl formate, propyl formate, butyl formate, methyl acetate, ethyl acetate, butyl acetate, propyl acetate, methyl propionate, ethyl propionate, propyl propionate, butyl propionate, methyl butyrate, ethyl butyrate, butyl butyrate, propyl butyrate, ethyl lactate, and butyl lactate, monocarboxylic acid esters such as methyl 2-oxypropionate, ethyl 2-oxypropionate, propyl 2-oxypropionate, butyl 2-oxypropionate, methyl 2-methoxypropionate, ethyl 2-methoxypropionate, propyl 2-methoxypropionate, and butyl 2-methoxypropionate; cellosolve esters such as cellosolve acetate, methyl cellosolve acetate, ethyl cellosolve acetate, propyl cellosolve acetate, and butyl cellosolve acetate; propylene glycols such as propylene glycol, propylene glycol monomethyl ether, propylene glycol monomethyl ether acetate, propylene glycol monoethyl ether acetate, and propylene glycol monobutyl ether acetate; diethylene glycols such as diethylene glycol monomethyl ether, diethylene glycol monoethyl ether, diethylene glycol dimethyl ether, diethylene glycol diethyl ether, and diethylene glycol methyl ethyl ether; halogenated hydrocarbons such as trichloroethylene, a chlorofluorocarbon solvent, HCFC, and HFC; completely fluorinated solvents such as perfluorooctane, aromatics such as toluene and xylene; and a polar solvent such as dimethyl acetamide, dimethyl formamide, N-methyl acetamide, and N-methyl pyrrolidone.

Only one type of such solvents may be used, or two or more types thereof can be used together.

In a case where the coating composition of the invention is a color resist composition, the color resist composition contains an alkali-soluble resin, a polymerizable compound, a colorant, and the like, in addition to the polymer of the invention.

As the alkali-soluble resin in the color resist, the same alkali-soluble resin as that in the photoresist composition described above can be used.

The polymerizable compound in the color resist composition, for example, is a compound having a photopolymerizable functional group that can be polymerized or crosslinked by the irradiation of an active energy ray such as an ultraviolet ray.

Examples of the polymerizable compound include an unsaturated carboxylic acid such as a (meth)acrylic acid, ester of a monohydroxy compound and an unsaturated carboxylic acid, ester of an aliphatic polyhydroxy compound and an unsaturated carboxylic acid, ester of an aromatic polyhydroxy compound and an unsaturated carboxylic acid, ester obtained by an esterification reaction between an unsaturated carboxylic acid and a polyvalent carboxylic acid, and a polyvalent hydroxy compound such as the aliphatic polyhydroxy compound and the aromatic polyhydroxy compound described above, a polymerizable compound having a urethane skeleton obtained by a reaction between a polyisocyanate compound and a (meth)acryloyl group-containing hydroxy compound, and a polymerizable compound having an acid group.

Only one type of the polymerizable compounds may be used, or two or more types thereof can be used together.

Examples of the ester of the aliphatic polyhydroxy compound and the unsaturated carboxylic acid include (meth)acrylic acid ester such as ethylene glycol di(meth)acrylate, triethylene glycol di(meth)acrylate, trimethylol propane tri(meth)acrylate, trimethylol ethane tri(meth)acrylate, pentaerythritol di(meth)acrylate, pentaerythritol tri(meth)acrylate, pentaerythritol tetra(meth)acrylate, dipentaerythritol tetra(meth)acrylate, dipentaerythritol penta(meth)acrylate, dipentaerythritol hexa(meth)acrylate, and glycerol (meth)acrylate.

In addition, examples of the ester also include itaconic acid ester in which a (meth)acrylic acid part of the acrylate is substituted with an itaconic acid, crotonic acid ester in which a (meth)acrylic acid part of the acrylate is substituted with a crotonic acid, or maleic acid ester in which a (meth)acrylic acid part of the acrylate is substituted with a maleic acid.

Examples of the ester of the aromatic polyhydroxy compound and the unsaturated carboxylic acid include hydroquinonedi(meth)acrylate, resorcine di(meth)acrylate, and pyrogallol tri(meth)acrylate.

The ester obtained by the esterification reaction between the unsaturated carboxylic acid and the polyvalent carboxylic acid, and the polyvalent hydroxy compound may be a single substance, or may be a mixture. Examples of such ester include ester obtained from a(meth)acrylic acid, a phthalic acid, and ethylene glycol, ester obtained from a (meth)acrylic acid, a maleic acid, and diethylene glycol, ester obtained from a (meth)acrylic acid, a terephthalic acid, and pentaerythritol, and ester obtained from a (meth)acrylic acid, an adipic acid, butane diol, and glycerin.

Examples of the polymerizable compound having the urethane skeleton that is obtained by the reaction between the polyisocyanate compound and the (meth)acryloyl group-containing hydroxy compound include aliphatic diisocyanate such as hexamethylene diisocyanate and trimethyl hexamethylene diisocyanate; alicyclic diisocyanate such as cyclohexane diisocyanate and isophorone diisocyanate; and a reactant of aromatic diisocyanate such as tolylene diisocyanate and diphenyl methane diisocyanate, and a hydroxy compound having a (meth)acryloyl group such as 2-hydroxyethyl (meth)acrylate and 3-hydroxy[1,1,1-tri(meth)acryloyl oxymethyl] propane.

The polymerizable compound having the acid group, for example, is ester of an aliphatic polyhydroxy compound and an unsaturated carboxylic acid, and is preferably a polyfunctional polymerizable compound having an acid group obtained by a reaction between a non-aromatic carboxylic anhydride and an unreacted hydroxyl group of an aliphatic polyhydroxy compound. As the aliphatic polyhydroxy compound used for the preparation of the polyfunctional polymerizable compound, pentaerythritol or dipentaerythritol is preferable.

The acid value of the polyfunctional polymerizable compound is preferably in a range of 0.1 to 40, and more preferably in a range of 5 to 30, from the viewpoint of excellent developability, curability, or the like. In a case where two or more types of polyfunctional polymerizable compounds having an acid group are used together, and in a case where a polyfunctional polymerizable compound having an acid group and a polyfunctional polymerizable compound not having an acid group are used together, it is preferable that the acid value of the mixture of the polymerizable compound is in the range described above.

Specific examples of the polymerizable compound having the acid group include a mixture containing dipentaerythritol hexaacrylate, dipentaerythritol pentaacrylate, and succinic acid ester of dipentaerythritol pentaacrylate, as a main component, and the mixture is commercially available as ARONIX TO-1382 (manufactured by TOAGOSEI CO., LTD.).

Examples of the other polymerizable compound include (meth)acryl amide such as ethylene bis(meth)acryl amide; allyl ester such as diallyl phthalate; and a compound having a vinyl group, such as divinyl phthalate.

In the color resist composition, the content of the polymerizable compound is preferably in a range of 5 to 80% by mass, more preferably in a range of 10 to 70% by mass, and even more preferably in a range of 20 to 50% by mass, in the total solid content of the color resist composition.

The colorant of the color resist composition is not particularly limited insofar as coloring is available, and for example, may be a pigment, or may be a dye.

As the pigment, either an organic pigment or an inorganic pigment can be used. As the organic pigment, pigments with each color phase, such as a red pigment, a green pigment, a blue pigment, a yellow pigment, a violet pigment, an orange pigment, and a brown pigment, can be used. In addition, examples of the chemical structure of the organic pigment include an azo-based structure, a phthalocyanine-based structure, a quinacridonebased structure, a benzimidazolon-based structure, an isoindolinone-based structure, a dioxazine-based structure, an indanthrene-based structure, and a perylene-based structure. In addition, examples of the inorganic pigment include barium sulfate, lead sulfate, titanium oxide, chrome yellow, bengala, and chromium oxide.

Note that "C.I." described below indicates a color index.

Examples of the red pigment include C.I. Pigment Reds 1, 2, 3, 4, 5, 6, 7, 8, 9, 12, 14, 15, 16, 17, 21, 22, 23, 31, 32, 37, 38, 41, 47, 48, 48:1, 48:2, 48:3, 48:4, 49, 49:1, 49:2, 50:1, 52:1, 52:2, 53, 53:1, 53:2, 53:3, 57, 57:1, 57:2, 58:4, 60, 63, 63:1, 63:2, 64, 64:1, 68, 69, 81, 81:1, 81:2, 81:3, 81:4, 83, 88, 90:1, 101, 101:1, 104, 108, 108:1, 109, 112, 113, 114, 122, 123, 144, 146, 147, 149, 151, 166, 168, 169, 170, 172, 173, 174, 175, 176, 177, 178, 179, 181, 184, 185, 187, 188, 190, 193, 194, 200, 202, 206, 207, 208, 209, 210, 214, 216, 220, 221, 224, 230, 231, 232, 233, 235, 236, 237, 238, 239, 242, 243, 245, 247, 249, 250, 251, 253, 254, 255, 256, 257, 258, 259, 260, 262, 263, 264, 265, 266, 267, 268, 269, 270, 271, 272, 273, 274, 275, and 276. Among them, C.I. Pigment Red 48:1, 122, 168, 177, 202, 206, 207, 209, 224, 242, or 254 is preferable, and C.I. Pigment Red 177, 209, 224, or 254 is more preferable.

Examples of the green pigment include C.I. Pigment Greens 1, 2, 4, 7, 8, 10, 13, 14, 15, 17, 18, 19, 26, 36, 45, 48, 50, 51, 54, 55, and 58. Among them, C.I. Pigment Green 7, 36, or 58 is preferable.

Examples of the blue pigment include C.I. Pigment Blues 1, 1:2, 9, 14, 15, 15:1, 15:2, 15:3, 15:4, 15:6, 16, 17, 19, 25, 27, 28, 29, 33, 35, 36, 56, 56:1, 60, 61, 61:1, 62, 63, 66, 67, 68, 71, 72, 73, 74, 75, 76, 78, and 79. Among them, C.I. Pigment Blue 15, 15:1, 15:2, 15:3, 15:4, or 15:6 is preferable, and C.I. Pigment Blue 15:6 is more preferable.

Examples of the yellow pigment include C.I. Pigment Yellows 1, 1:1, 2, 3, 4, 5, 6, 9, 10, 12, 13, 14, 16, 17, 24, 31, 32, 34, 35, 35:1, 36, 36:1, 37, 37:1, 40, 41, 42, 43, 48, 53, 55, 61, 62, 62:1, 63, 65, 73, 74, 75, 81, 83, 87, 93, 94, 95, 97, 100, 101, 104, 105, 108, 109, 110, 111, 116, 117, 119, 120, 126, 127, 127:1, 128, 129, 133, 134, 136, 138, 139, 142, 147, 148, 150, 151, 153, 154, 155, 157, 158, 159, 160, 161, 162, 163, 164, 165, 166, 167, 168, 169, 170, 172, 173, 174, 175, 176, 180, 181, 182, 183, 184, 185, 188, 189, 190, 191, 191:1, 192, 193, 194, 195, 196, 197, 198, 199, 200, 202, 203, 204, 205, 206, 207, and 208. Among them, C.I. Pigment Yellow 83, 117, 129, 138, 139, 150, 154, 155, 180, or 185 is preferable, and C.I. Pigment Yellow 83, 138, 139, 150, or 180 is more preferable.

Examples of the violet pigment include C.I. Pigment Violets 1, 1:1, 2, 2:2, 3, 3:1, 3:3, 5, 5:1, 14, 15, 16, 19, 23, 25, 27, 29, 31, 32, 37, 39, 42, 44, 47, 49, and 50. Among them, C.I. Pigment Violet 19 or 23 is preferable, and C.I. Pigment Violet 23 is more preferable.

Examples of the orange pigment include C.I. Pigment Oranges 1, 2, 5, 13, 16, 17, 19, 20, 21, 22, 23, 24, 34, 36, 38, 39, 43, 46, 48, 49, 61, 62, 64, 65, 67, 68, 69, 70, 71, 72, 73, 74, 75, 77, 78, and 79. Among them, C.I. Pigment Orange 38 or 71 is preferable.

Since three primary colors of pixels in a color filter that is used in a liquid crystal display apparatus and an organic EL display apparatus are red (R), green (G), and blue (B), the red pigment, the green pigment, and the blue pigment may be used as a main component, and organic pigments with colors of yellow, violet, orange, and the like may be used as color phase adjustment in order to improve color reproducibility.

The average particle diameter of the organic pigment is preferably 1 µm or less, more preferably 0.5 µm or less, and even more preferably 0.3 µm or less, in order to increase the luminance of the color liquid crystal display apparatus and the organic EL display apparatus. It is preferable to use the organic pigment by dispersing the organic pigment to have the average particle diameter described above.

The average primary particle diameter of the organic pigment is preferably 100 nm or less, more preferably 50 nm or less, even more preferably 40 nm or less, and particularly preferably in a range of 10 to 30 nm.

Note that the average particle diameter of the organic pigment is measured by a dynamic light scattering particle size distribution analyzer, and for example, can be measured by a Nanotrac particle size distribution analyzer "UPA-EX150", "UPA-EX250", or the like, manufactured by Nikkiso Co., Ltd.

The colorant in a case where the color resist composition is used to form a black matrix (BM) is not particularly limited insofar as the colorant is black, and examples thereof include carbon black, lamp black, acetylene black, bone black, thermal black, channel black, furnace black, graphite, iron black, and titanium black. Among them, the carbon black and the titanium black are preferable from the viewpoint of a light shielding property and an image property.

In addition, two or more types of organic pigments may be mixed to be black.

Examples of a commercially available product of the carbon black include MA7, MA8, MA11, MA100, MA100R, MA220, MA230, MA600, #5, #10, #20, #25, #30, #32, #33, #40, #44, #45, #47, #50, #52, #55, #650, #750, #850, #950, #960, #970, #980, #990, #1000, #2200, #2300, #2350, #2400, #2600, #3050, #3150, #3250, #3600, #3750, #3950, #4000, #4010, OIL7B, OIL9B, OIL11B, OIL30B, and OIL31B, manufactured by Mitsubishi Chemical Corporation, Printex 3, Printex 3OP, Printex 30, Printex 30OP, Printex 40, Printex 45, Printex 55, Printex 60, Printex 75, Printex 80, Printex 85, Printex 90, Printex A, Printex L, Printex G, Printex P, Printex U, Printex V, Printex G, Special Black 550, Special Black 350, Special Black 250, Special Black 100, Special Black 6, Special Black 5, Special Black 4, Color Black FW1, Color Black FW2, Color Black FW2V, Color Black FW18, Color Black FW18, Color Black FW200, Color Black S160, and Color Black S170, manufactured by Evonik Degussa Japan Co., Ltd., Monarch 120, Monarch 280, Monarch 460, Monarch 800, Monarch 880, Monarch 900, Monarch 1000, Monarch 1100, Monarch 1300, Monarch 1400, Monarch 4630, REGAL 99, REGAL 99R, REGAL 415, REGAL 415R, REGAL 250, REGAL 250R, REGAL 330, REGAL 400R, REGAL 55R0, REGAL 660R, BLACK PEARLS 480, PEARLS 130, VULCAN XC72R, and ELFTEX-8, manufactured by Cabot Corporation, RAVEN 11, RAVEN 14, RAVEN 15, RAVEN 16, RAVEN 22, RAVEN 30, RAVEN 35, RAVEN 40, RAVEN 410, RAVEN 420, RAVEN 450, RAVEN 500, RAVEN 780, RAVEN 850, RAVEN 890H, RAVEN 1000, RAVEN 1020, RAVEN 1040, RAVEN 1060U, RAVEN 1080U, RAVEN 1170, RAVEN 1190U, RAVEN 1250, RAVEN 1500, RAVEN 2000, RAVEN 2500U, RAVEN 3500, RAVEN 5000, RAVEN 5250, RAVEN 5750, and RAVEN 7000, manufactured by Columbian Carbon Corporation.

Among the carbon blacks described above, carbon black covered with a resin is preferable as having a high optical concentration and a high surface resistivity required for the black matrix of the color filter.

Examples of a commercially available product of the titanium black include Titanium Blacks 10S, 12S, 13R, 13M, and 13M-C, manufactured by Mitsubishi Materials Corporation.

As the colorant when used to form the black matrix (BM), two or more types of organic pigments may be mixed to be black, and examples of the colorant include a black pigment obtained by mixing three color pigments of red, green, and blue.

Examples of a color material that can be mixed to prepare the black pigment include Victoria Pure Blue (C.I. 42595), Auramine O (C.I. 41000), Cathilon Brilliant Flavin (Basic 13), Rhodamine 6GCP (C.I. 45160), Rhodamine B (C.I. 45170), Safranin OK70:100 (C.I. 50240), Erioglaucin X (C.I. 42080), No.120/Lionol Yellow (C.I. 21090), Lionol Yellow GRO (C.I. 21090), Symuler Fast Yellow 8GF (C.I. 21105), Benzidine Yellow 4T-564D (C.I. 21095), Symuler Fast Red 4015 (C.I. 12355), Lionol Red 7B4401 (C.I. 15850), Fastogen Blue TGR-L (C.I. 74160), Lionol Blue SM (C.I. 26150), Lionol Blue ES (C.I. Pigment Blue 15:6), Lionogen Red GD (C.I. Pigment Red 168), and Lionol Green 2YS (C.I. Pigment Green 36).

Examples of the other color material that can be mixed to prepare the black pigment include C.I. Yellow Pigments 20, 24, 86, 93, 109, 110, 117, 125, 137, 138, 147, 148, 153, 154, and 166, C.I. Orange Pigments 36, 43, 51, 55, 59, and 61, C.I. Red Pigments 9, 97, 122, 123, 149, 168, 177, 180, 192, 215, 216, 217, 220, 223, 224, 226, 227, 228, and 240, C.I. Violet Pigments 19, 23, 29, 30, 37, 40, and 50, C.I. Blue Pigments 15, 15:1, 15:4, 22, 60, and 64, C.I. Green Pigment 7, and C.I. Brown Pigments 23, 25, and 26.

In a case where carbon black is used as the black pigment, the average primary particle diameter of the carbon black is preferably in a range of 0.01 to 0.08 µm, and more preferably in a range of 0.02 to 0.05 µm from the viewpoint of excellent developability.

The carbon black has a particle shape different from that of the organic pigment or the like, is in a state referred to as a structure in which the primary particles are fused to each other, and may form fine pores on the particle surface by an aftertreatment. Therefore, in order to represent the particle shape of the carbon black, in general, it is preferable to measure a DBP absorbed amount (JIS K6221) and a specific surface area (JIS K6217) by a BET method to be an index of a structure or a pore volume, in addition to the average particle diameter of the primary particles that is obtained by the same method as that of the organic pigment.

The dibutyl phthalate (hereinafter, will be abbreviated as "DBP") absorbed amount of the carbon black is preferably in a range of 40 to 100 cm³/100 g, and more preferably in a range of 50 to 80 cm³/100 g from the viewpoint of excellent dispersibility and developability. The specific surface area of the carbon black by the BET method is preferably in a range of 50 to 120 m²/g, and more preferably in a range of 60 to 95 m²/g from the viewpoint of excellent dispersion stability.

Examples of the dye as the colorant in the color resist composition include an azo-based dye, an anthraquinone-based dye, a phthalocyanine-based dye, a quinone imine-based dye, a quinoline-based dye, a nitro-based dye, a carbonyl-based dye, and a methine-based dye.

Examples of the azo-based dye include C.I. Acid Yellow 11, C.I. Acid Orange 7, C.I. Acid Red 37, C.I. Acid Red 180, C.I. Acid Blue 29, C.I. Direct Red 28, C.I. Direct Red 83, C.I. Direct Yellow 12, C.I. Direct Orange 26, C.I. Direct Green 28, C.I. Direct Green 59, C.I. Reactive Yellow 2, C.I. Reactive Red 17, C.I. Reactive Red 120, C.I. Reactive Black 5, C.I. Disperse Orange 5, C.I. Disperse Red 58, C.I. Disperse Blue 165, C.I. Basic Blue 41, C.I. Basic Red 18, C.I. Mordant Red 7, C.I. Mordant Yellow 5, and C.I. Mordant Black 7.

Examples of the anthraquinone-based dye include C.I. Vat Blue 4, C.I. Acid Blue 40, C.I. Acid Green 25, C.I. Reactive Blue 19, C.I. Reactive Blue 49, C.I. Disperse Red 60, C.I. Disperse Blue 56, and C.I. Disperse Blue 60.

Examples of the phthalocyanine-based dye include C.I. Pad Blue 5, examples of the quinone imine-based dye include C.I. Basic Blue 3 and C.I. Basic Blue 9, examples of the quinoline-based dye include C.I. Solvent Yellow 33, C.I. Acid Yellow 3, and C.I. Disperse Yellow 64, and examples of the nitro-based dye include C.I. Acid Yellow 1, C.I. Acid Orange 3, and C.I. Disperse Yellow 42.

It is preferable to use a pigment as the colorant in the color resist composition, from the viewpoint of excellent light resistance, weather resistance, and solidity of the coated film to be obtained, and as necessary, a dye may be used together in the pigment in order to adjust the color phase.

In the color resist composition, the content of the colorant is preferably 1% by mass or more, more preferably in a range of 5 to 80% by mass, and even more preferably in a range of 5 to 70% by mass, in the total solid content of the color resist composition.

In a case where the color resist composition is used to form each of the pixels of red (R), green (G), and blue (B) in the color filter, the content of the colorant in the color resist composition is preferably in a range of 5 to 60% by mass, and more preferably in a range of 10 to 50% by mass, in the total solid content of the color resist composition.

In a case where the color resist composition is used to form the black matrix of the color filter, the content of the colorant in the color resist composition is preferably in a range of 20 to 80% by mass, and more preferably in a range of 30 to 70% by mass, in the total solid content of the color resist composition.

In the color resist composition, in a case where the colorant is a pigment, it is preferable to use the pigment as a pigment dispersion prepared by dispersing the pigment in an organic solvent using a dispersant.

Examples of the dispersant include a surfactant; an intermediate or a derivative of a pigment; an intermediate or a derivative of a dye; and a resin-type dispersant such as a polyamide-based resin, a polyurethane-based resin, a polyester-based resin, and an acrylic resin. Among them, a graft copolymer having a nitrogen atom, an acrylic block copolymer having a nitrogen atom, a urethane resin dispersant, and the like are preferable. Since such dispersants have a nitrogen atom, the nitrogen atom has affinity to the surface of the pigment, and a part other than the nitrogen atom increases affinity to a medium, and thus, the dispersion stability is improved.

Only one type of such dispersants may be used, or two or more types thereof can be used together.

Examples of a commercially available product of the dispersant include "EFKA" Series (such as ""EFKA 46"), manufactured by BASF; "Disperbyk" Series, and "BYK" Series (such as "BYK-160", "BYK-161", and "BYK-2001"), manufactured by BYK Japan KK; "Solsperse" Series, manufactured by The Lubrizol Corporation; "KP" Series, manufactured by Shin-Etsu Chemical Co., Ltd., "Polyflow" Series, manufactured by KYOEISHA CHEMICAL Co., LTD.; "DISPARLON" Series, manufactured by Kusumoto Chemicals, Ltd.; and "AJISPER" Series (such as "AJISPER PB-814"), manufactured by Ajinomoto Fine-Techno Co., Inc..

Examples of the organic solvent used when preparing the pigment dispersion include acetic acid ester-based solvent such as propylene glycol monomethyl ether acetate, and propylene glycol monoethyl ether acetate; a propionate-based solvent such as ethoxypropionate; an aromatic-based solvent such as toluene, xylene, and methoxybenzene; an ether-based solvent such as butyl cellosolve, propylene glycol monomethyl ether, diethylene glycol ethyl ether, and diethylene glycol dimethyl ether; a ketone-based solvent such as methyl ethyl ketone, methyl isobutyl ketone, and cyclohexanone; an aliphatic hydrocarbon-based solvent such as hexane; a nitrogen compound-based solvent such as N,N-dimethyl formamide, γ-butyrolactam, and N-methyl-2-pyrrolidone; a lactone-based solvent such as γ-butyrolactone; and carbamic acid ester.

Only one type of such solvents may be used, or two or more types thereof can be used together.

Examples of a method for preparing the pigment dispersion include a method including a kneading and dispersing step and a microdispersing step of the colorant, and a method only including the microdispersing step. In the kneading and dispersing step, the colorant, a part of the alkali-soluble resin, and as necessary, the dispersant are mixed and kneaded. By performing dispersing while imparting a strong shearing force using a kneader, it is possible to disperse the colorant.

Examples of a machine used in kneading include a double roll, a triple roll, a ball mill, a trommel, a disperser, a kneader, a co-kneader, a homogenizer, a blender, and a single screw or twin screw extruder.

It is preferable to refine the particle size of the colorant by a salt milling method or the like before the kneading described above.

In the microdispersing step, the solvent is added to the composition containing the colorant obtained in the kneading and dispersing step, or the colorant, the alkali-soluble resin, the solvent, and as necessary, the dispersant are mixed, and then, mixed and dispersed together with a fine particle dispersion medium of glass, zirconia, or ceramic by using a disperser, and thus, the particles of the colorant can be dispersed to a fine state close to the primary particles.

From the viewpoint of improving the transmittance, the contrast, or the like of the color filter, the average particle diameter of the primary particles of the colorant is preferably 10 to 100 nm, and more preferably 10 to 60 nm. Note that the average particle diameter of the colorant is measured by a dynamic light scattering particle size distribution analyzer, and for example, can be measured by a Nanotrac particle size distribution analyzer "UPA-EX150", "UPA-EX250", or the like, manufactured by Nikkiso Co., Ltd.

As described above, the composition for a coating material, the photoresist composition, and the color resist composition have been exemplified as the coating composition, but the coating composition is not limited thereto.

Specific example of the application of the coating composition of the invention include an anti-glare (AG) hard coat material, an anti-reflection (LR) coat material, a low refractive layer coat material, a high refractive layer coat material, a clear hard coat material, and a polymerizable liquid crystal coat material, which are a coat material for various display screens such as a liquid crystal display (hereinafter, will be abbreviated as "LCD"), a plasma display (hereinafter, will be abbreviated as "PDP"), an organic EL display (hereinafter, will be abbreviated as "OLED"), and a quantum dot display (hereinafter, will be abbreviated as "QDD"); a color resist, an inkjet ink, a printing ink, or a coating material for forming each pixel of RGB in a color filter (hereinafter, will be abbreviated as "CF") of the LCD or the like; a black resist, an inkjet ink, a printing ink, or a coating material for forming a black matrix, a black column spacer, and a black photospacer in the CF of the LCD or the like; a coating material for a transparent protective film for protecting the surface of the CF, which is used in the CF of the LCD or the like; a liquid crystal material of the LCD, and a resin composition for the column spacer and the photospacer; a resin composition for a pixel division wall of the LCD, the PDP, the OLED, the QDD, or the like, a positive photoresist for forming an electrode, a protective film, an insulating film, a plastic housing, a coating material for the plastic housing, and a bezel (frame) ink; a prism sheet that is a backlight member of the LCD, and a light diffusing film; a coating material for an organic insulating film of a liquid crystal TFT array of the LCD; an internal polarization plate surface protective coat material of the LCD; a phosphor of the PDP; an organic EL material and a sealing material (a protective film and a gas barrier) of the OLED; a quantum dot ink, a sealing material, and a protective film of the QDD; a high refractive index lens, low refractive index sealing, and an LED pixel of a micro(mini)-LED display; a positive photoresist, a chemical amplified photoresist, an anti-reflection film, a multi-layer material (SOC, SOG), a bottom layer, a buffer coat, a drug solution such as a developer, a rinse agent, a pattern collapse inhibitor, a polymer residue remover, and a washing agent, and a nanoimprint release agent, which are used to produce a semiconductor; a resin composition (a resin composition such as an epoxy resin, a phenol resin, a polyphenylene ether resin, a liquid crystal polymer, a polyimide resin, a bismaleimide resin, a bisallyl nadimide resin, and a benzooxazine resin) for a semiconductor post-process or a printed wiring board, a copper clad laminate, a copper foil with a resin, a build-up film, a passivation film, an interlayer insulating film, a flexible copper clad laminate, and a dry film resist; a color resist for an image sensor; a liquid repellent for solder flux; a dispersant, a coating material, and a green sheet for a laminated ceramic capacitor; a cathode material, an anode material, a separator, and an electrolyte for a lithium-ion battery; an exterior coating material, rubber, an elastomer, glass, a vapor-deposition material anchor coat, a head lamp lens, a solid lubrication coating material, a heat release substrate, an interior coating material, and a coating material for repairs for an automobile; wallpaper, flooring, a kitchen member, and a bathroom/toilet member for household equipment; an inkjet ink, an offset printing ink, a gravure printing ink, a screen printing ink, a photoresist for printing plate producing step, a photosensitive material for a planographic printing plate (PS plate), a package adhesive agent, and a ballpoint pen ink for a printed matter; a primer for easy adhesion of a plastic film; a water repellent for a fiber; a non-diffusing agent for grease; a washing liquid for washing the surface of various products or components; a hard coat material for an optical recording medium such as a CD, a DVD, and a Blu-ray disc; a coating material or a hard coat material for a housing or a screen of a smart phone or a mobile phone; a hard coat material for an insert molding (IMD, IMF) transfer film; a mold release film; a coating material or a coat material for various plastic parts such as a housing of a home electrical appliance; a printing ink or a coating material for various building materials such as a decorative laminate; a coat material for a window pane of a house; a coating material for woodworking such as furniture; a coat material for artificial/synthetic leather; a coat material for a rubber roller in OA equipment such as a copier and a printer; a coat material for glass of a reading unit in OA equipment such as a copier and a scanner; an optical lens such as a camera, a video camera, spectacles, and a contact lens, or a coat material thereof; a coat material for windshield and glass of a watch such as a wrist watch; a coat material for window of various vehicles such as an automobile and a rail vehicle; a coating material for cover glass of a solar battery or an anti-reflection film of a film; a coating material or a coat material for a FRP bath; PCM for a metal building material or a home electrical appliance product; and a single-layer or multi-layer coating composition for a photofabrication process or the like.

The copolymer of the invention has excellent surface tension reduction ability, and thus, it is possible to expect not only simply the leveling property, but also each function such as wettability, permeability, washability, water repellency, oil repellency, an antifouling property, lubricity, an antiblocking property, and mold releasability. In addition, in a case where the polymer of the invention is compounded in a coating material or a coating agent containing fine particles, the dispersibility of the fine particles is improved, and thus, it is possible to expect not only simply the leveling property, but also a function as a dispersant of the fine particles. In addition, the polymer of the invention is added to a pressure-sensitive adhesive agent composition that is used for a pressure-sensitive adhesive tape or the like, in addition to the coating composition, and thus, it is possible to expect not only simply the leveling property, but also each function such as a reduction in a peeling force, the suppression of a fluctuation in the peeling force, and the suppression of peeling electrification.

### EXAMPLES

Hereinafter, the invention will be described in detail by Examples and Comparative Examples.

Note that the invention is not limited to Examples described below.

A GPC measurement condition for a silicone-containing copolymer obtained in Examples and Comparative Examples described below is as follows.

### [GPC Measurement Condition]

Measurement Apparatus: "HLC-8220 GPC", manufactured by Tosoh Corporation
Column: a guard column "HHR-H" (6.0 mm I.D. × 4 cm), manufactured by Tosoh Corporation
+ "TSK-GEL GMHHR-N" (7.8 mm I.D. × 30 cm), manufactured by Tosoh Corporation
+ "TSK-GEL GMHHR-N" (7.8 mm I.D. × 30 cm), manufactured by Tosoh Corporation
+ "TSK-GEL GMHHR-N" (7.8 mm I.D. × 30 cm), manufactured by Tosoh Corporation
+ "TSK-GEL GMHHR-N" (7.8 mm I.D. × 30 cm), manufactured by Tosoh Corporation
Detector: an evaporative light scattering detector (manufactured by Altech Japan Co., Ltd., "ELSD2000")
Data Processing: "GPC-8020 model II data analysis version 4.30", manufactured by Tosoh Corporation
Measurement Condition: Column Temperature: 40°C
   Developing Solvent: tetrahydrofuran (THF)
   Flow Rate: 1.0 ml/minute
Specimen: 1.0% by mass of a tetrahydrofuran solution in terms of solid content was filtered with a microfilter (5 µl).
Reference Specimen: the following monodispersed polystyrenes with a known molecular weight were used on the basis of a measurement manual of "GPC-8020 model II data analysis version 4.30" described above.

### (Monodispersed Polystyrene)

"A-500", manufactured by Tosoh Corporation
"A-1000", manufactured by Tosoh Corporation
"A-2500", manufactured by Tosoh Corporation
"A-5000", manufactured by Tosoh Corporation
"F-1", manufactured by Tosoh Corporation
"F-2", manufactured by Tosoh Corporation
"F-4", manufactured by Tosoh Corporation
"F-10", manufactured by Tosoh Corporation
"F-20", manufactured by Tosoh Corporation
"F-40", manufactured by Tosoh Corporation
"F-80", manufactured by Tosoh Corporation
"F-128", manufactured by Tosoh Corporation
"F-288", manufactured by Tosoh Corporation
"F-550", manufactured by Tosoh Corporation

### Example 1: Synthesis of Silicone-Containing Copolymer (1)

A mixed liquid A1 in which 180.0 g of adamantyl methacrylate that is a commercially available product was mixed with 70.0 g of butyl acetate as a solvent, a mixed liquid B1 in which 3.0 g of t-butyl peroxy-2-ethyl hexanoate as a polymerization initiator was mixed with 10.0 g of butyl acetate as a solvent, and a mixed liquid C1 in which 20.0 g of a monomethacrylate compound having a polysiloxane bond represented by the following formula that is a commercially available product was mixed with 20.0 g of butyl acetate as a solvent were prepared, respectively.

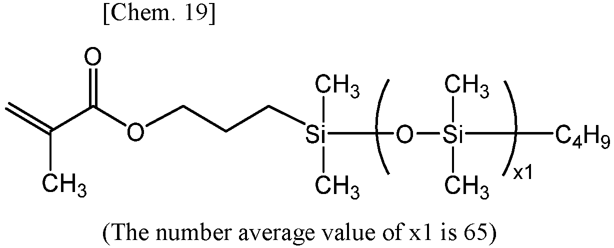

200.0 g of butyl acetate as a solvent was prepared in a glass flask provided with a stirrer, a thermometer, a cooling pipe, and a dripper, and heated to 90°C while stirring under a nitrogen stream.

The mixed liquid A1 was dripped to such a flask at 95°C for 135 minutes. In 5 minutes after the dripping of the mixed liquid A1 was started, the dripping of the mixed liquid B1 and the mixed liquid C1 at 95°C was started. The dripping of the mixed liquid C1 was ended in 120 minutes after the dripping was started, and the dripping of the mixed liquids A1 and B1 was ended in 10 minutes after the dripping of the mixed liquid C1 was ended (in 135 minutes after the dripping of the mixed liquid A1 was started). After the dripping was ended, stirring was performed at 95°C for 10 hours. After the reaction was ended, 500 g of butyl acetate was added to obtain a butyl acetate solution containing 20% by mass of a silicone-containing copolymer (1).

The molecular weight of the obtained silicone-containing copolymer (1) was measured by GPC, and as a result thereof, the weight average molecular weight (Mw) was 26000.

In addition, a content ratio of a polymerizable unsaturated monomer having a silicone chain was 10% by mass from a preparation ratio of raw materials.

### Comparative Example 1: Synthesis of Silicone-Containing Copolymer (2)

A mixed liquid A1' in which 180.0 g of polypropylene glycol-polybutylene glycolmonomethacrylate (the average number of repetitions of propylene glycol is 1, and the average number of repetitions of butylene glycol is 6) that is a commercially available product was mixed with 70.0 g of butyl acetate as a solvent, a mixed liquid B1' in which 3.0 g of t-butyl peroxy-2-ethyl hexanoate as a polymerization initiator was mixed with 10.0 g of butyl acetate as a solvent, and a mixed liquid C1' in which 20.0 g of a monomethacrylate compound having a polysiloxane bond that is the same as that in Synthesis Example 1 was mixed with 20.0 g of butyl acetate as a solvent were prepared, respectively.

200.0 g of butyl acetate as a solvent was prepared in a glass flask provided with a stirrer, a thermometer, a cooling pipe, and a dripper, and heated to 90°C while stirring under a nitrogen stream.

The dripping of the mixed liquid A1' at 90°C was started in the flask, and the dripping of the mixed liquid B1' and the mixed liquid C1' at 90°C was started in 5 minutes after the dripping of the mixed liquid A1' was started. The dripping of the mixed liquid C1' was ended in 120 minutes after the dripping was started, and the dripping of the mixed liquids A1' and B1' was ended in 10 minutes after the dripping of the mixed liquid C1' was ended (in 135 minutes after the dripping of the mixed liquid A1' was started). After the dripping was ended, stirring was performed at 90°C for 10 hours. After the reaction was ended, the solvent was distilled away to obtain a silicone-containing copolymer (2).

The molecular weight of the obtained silicone-containing copolymer (2) was measured by GPC, and as a result thereof, the weight average molecular weight (Mw) was 38000.

In addition, a content ratio of a polymerizable unsaturated monomer having a silicone chain in the silicone-containing copolymer (2) was 10% by mass from a preparation ratio of raw materials.

The molecular weight of the obtained silicone-containing copolymer (2) was measured by GPC, and as a result thereof, the weight average molecular weight (Mw) was 17000.

In addition, a content ratio of a polymerizable unsaturated monomer having a silicone chain in the silicone-containing copolymer (2) was 67% by mass from a preparation ratio of raw materials.

### Comparative Example 2: Synthesis of Silicone-Containing Copolymer (3)

A mixed liquid A2' in which 45.0 g of 1-adamantyl methacrylate, 55.0 g of a monomethacrylate compound having a polysiloxane bond represented by the following formula that is a commercially available product, and 70.0 g of butyl acetate as a solvent were mixed, and a mixed liquid B2' in which 3.0 g of t-butyl peroxy-2-ethyl hexanoate as a polymerization initiator was mixed with 63.3 g of butyl acetate as a solvent were prepared, respectively.

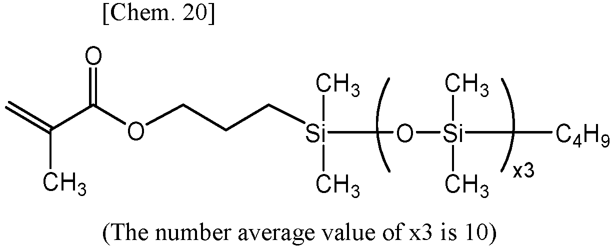

100.0 g of butyl acetate as a solvent was prepared in a glass flask provided with a stirrer, a thermometer, a cooling pipe, and a dripper, and heated to 90°C while stirring under a nitrogen stream.

The mixed liquid A2' was dripped to the flask at 90°C for 120 minutes, and the mixed liquid B2' was dripped to the flask at 90°C for 140 minutes. After the dripping was ended, stirring was performed at 90°C for 5 hours. After the reaction was ended, 166.7 g of butyl acetate was added to obtain a butyl acetate solution containing 20% by mass of a silicone-containing copolymer (3).

The molecular weight of the obtained silicone-containing copolymer (3) was measured by GPC, and as a result thereof, the weight average molecular weight (Mw) was 15000.

In addition, a content ratio of a polymerizable unsaturated monomer having a silicone chain in the silicone-containing copolymer (3) was 55% by mass from a preparation ratio of raw materials.

### [Film Formation and Evaluation of Coated Film]

For the silicone-containing copolymers (1) to (3) synthesized in Examples and Comparative Examples, a coated film was formed, and a leveling property and the repressibility of foreign substances due to the sublimation of a pigment were evaluated.

### (1) Leveling Property

By using the silicone-containing copolymer synthesized in each of the examples, a coated film was formed as follows.

3.0 g of a binder resin (ACRYDIC ZL-295, manufactured by DIC CORPORATION), 1.2 g of ARONIX M-402 (manufactured by TOAGOSEI CO., LTD., a mixture of dipentaerythritol pentaacrylate and dipentaerythritol hexaacrylate), 0.002 g of the silicone-containing copolymer in terms of solid content, which was synthesized in each of the examples, and 8.1 g of PGMEA were mixed to prepare a resist composition.

3 ml of the obtained resist composition was dripped to the central portion of a chromium-plated glass substrate of 10 cm × 10 cm, and subjected to spin coating in a condition of a rotation frequency of 500 rpm and a rotation time of 30 seconds, and then, heated and dried at 110°C for 2 minutes by using a hot plate to prepare a coated film.

The coated film prepared as described above was visually observed, and evaluated in accordance with the following criteria. Results are shown in Table 1.
A: almost no unevenness is observed in the coated film.
B: the unevenness is observed in a part of the coated film.
C: the unevenness is observed in the entire coated film.

### (2) Repressibility of Generation of Foreign Substances on Surface of Coated Film due to Sublimation of Pigment

By using the silicone-containing copolymer produced in each of the examples, a coated film containing a pigment was formed as follows.

10 g of C.I. Pigment Red 254 (manufactured by BASF, "IRGAPHOR RED BT-CF") that is a red pigment was put in a plastic bottle, 44 g of PGMEA, 12 g of DISPERBYK LPN21116 (manufactured by BYK-Chemie GmbH), and SEPR beads with a diameter of 0.3 to 0.4 mm were added, and dispersed for 2 hours by a paint conditioner (manufactured by Toyo Seiki Seisaku-sho, Ltd.) to obtain a red pigment dispersion.

Next, 1.5 g of a binder resin (UNIDIC RS20-160, manufactured by DIC CORPORATION), 0.6 g of ARONIX M-402 (manufactured by TOAGOSEI CO., LTD.) as a photopolymerizable monomer, 0.05 g of Irgacure #369 (manufactured by BASF Japan Ltd.) as a photopolymerization initiator, 0.0014 g of the silicone-containing copolymer of each of the examples in terms of solid content, and 2.2 g of PGMEA were added and mixed with 5.9 g of the red pigment dispersion described above to prepare a color resist composition.

The obtained color resist composition was subjected to spin coating on a glass plate of 7 cm × 7 cm square in a condition of a rotation frequency of 1000 rpm and a rotation time of 10 seconds, and then, dried at 80°C for 3 minutes. After drying, exposure was performed at 50 mJ/cm² by using a high-pressure mercury lamp to form a coated film. After that, the coated film was heated at 270°C for 1 hour, and then, the coated film was observed with a digital microscope VHX-900 (manufactured by KEYENCE CORPORATION), and evaluated in accordance with the following criteria. Evaluation results are shown in Table 1.

A: the number of foreign substances due to the sublimation of the pigment that can be checked in the coated film of 1 cm × 1 cm square is 1 or less.
B: the number of foreign substances due to the sublimation of the pigment that can be checked in the coated film of 1 cm × 1 cm square is 2 to 9 on average.
C: the number of foreign substances due to the sublimation of the pigment that can be checked in the coated film of 1 cm × 1 cm square is 10 or more on average.

**[Table 1]**

| | Example 1 | Comparative Example 1 | Comparative Example 2 |
|---|---|---|---|
| Silicone-Containing Copolymer | (1) | (2) | (3) |
| Applicability | A | A | A |
| Repressibility of Generation of Foreign Substances on Surface of Coated Film | A | C | C |

It is found that the coated film of Example 1 that contains the silicone-containing copolymer of the invention as a leveling agent is excellent in applicability, and there is no generation of the foreign substances due to the sublimation of the pigment on the surface of the coated film. On the other hand, in Comparative Example 1 in which the weight average molecular weight of the silicone-containing copolymer is greater than that in Example 1, and the polymerizable monomer does not have a group including a cyclic hydrocarbon skeleton, the foreign substances due to the sublimation of the pigment in the coated film are generated on the surface of the coated film. Similarly, in Comparative Example 2, the foreign substances due to the sublimation of the pigment in the coated film are generated on the surface of the coated film.

## Claims

1. A silicone-containing copolymer, comprising:
a polymerizable monomer (A) having a group represented by General Formula (a) described below; and
a polymerizable monomer (B) having a group including a cyclic hydrocarbon skeleton, as at least a polymerization component, 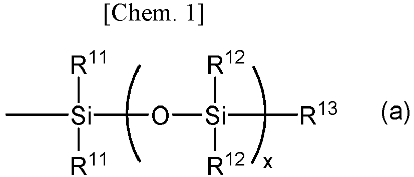 in General Formula (a) described above,
R¹¹s are each independently an alkyl group having 1 to 6 carbon atoms or a group represented by -OSi(R¹⁴)₃ (R¹⁴s are each independently an alkyl group having 1 to 3 carbon atoms),
R¹²s are each independently an alkyl group having 1 to 6 carbon atoms,
R¹³ is an alkyl group having 1 to 6 carbon atoms, and
x is a number average value indicating the number of repetitions, and is an integer of 20 to 150.

2. The silicone-containing copolymer according to claim 1,
wherein the polymerizable monomer (A) is a compound represented by General Formula (a-1) described below, 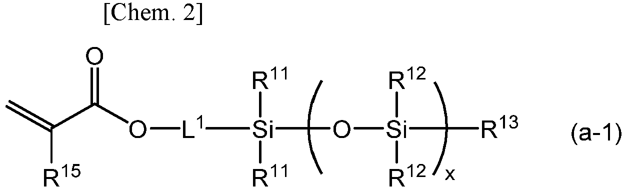 in General Formula (a-1) described above,
R¹¹, R¹², R¹³, and x are identical to R¹¹, R¹², R¹³, and x in General Formula (a) described above, respectively,
R¹⁵ is a hydrogen atom or a methyl group, and
L¹ is a divalent organic group.

3. The silicone-containing copolymer according to claim 1 or 2,
wherein the polymerizable monomer (B) is a polymerizable monomer represented by General Formula (b-1) described below, 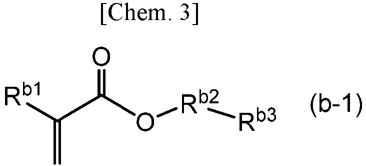 in General Formula (b-1) described above,
R^{b1} is a hydrogen atom or an alkyl group having 1 to 6 carbon atoms,
R^{b2} is an alkylene group having 1 to 10 carbon atoms, an arylene group having 6 to 18 carbon atoms, or a divalent linking group consisting of two or more types of combinations selected from an alkylene group having 1 to 10 carbon atoms, an arylene group having 6 to 18 carbon atoms and an ether bond (-O-), and
R^{b3} is a group including a cyclic hydrocarbon skeleton.

4. The silicone-containing copolymer according to any one of claims 1 to 3,
wherein the group including the cyclic hydrocarbon skeleton has a bridged ring structure.

5. The silicone-containing copolymer according to claim 4,
wherein the group including the cyclic hydrocarbon skeleton structure that has the bridged ring structure is an adamantane ring, a dicyclopentane ring, a dicyclopentene ring, a norbornane ring, a norbornene ring, a cyclohexane ring, or an isobornane ring.

6. The silicone-containing copolymer according to any one of claims 1 to 5,
wherein a weight average molecular weight (Mw) is 3000 to 80000.

7. The silicone-containing copolymer according to any one of claims 1 to 6,
wherein the silicone-containing copolymer does not contain a fluorine atom.

8. A leveling agent, comprising
the silicone-containing copolymer according to any one of claims 1 to 7.

9. A coating composition, comprising
the silicone-containing copolymer according to any one of claims 1 to 7.

10. A resist composition, comprising:
the silicone-containing copolymer according to any one of claims 1 to 7; and
a colorant.

11. A color filter in which a coated film layer of the resist composition according to claim 10 is formed on a substrate.

12. A method for producing a silicone-containing copolymer in which a polymerizable monomer (A) having a group represented by General Formula (a) described below and a polymerizable monomer (B) having a group including a cyclic hydrocarbon skeleton are polymerized, 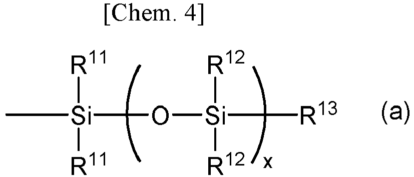 in General Formula (a) described above,
R¹¹s are each independently an alkyl group having 1 to 6 carbon atoms or a group represented by -OSi(R¹⁴)₃ (R¹⁴s are each independently an alkyl group having 1 to 3 carbon atoms),
R¹²s are each independently an alkyl group having 1 to 6 carbon atoms,
R¹³ is an alkyl group having 1 to 6 carbon atoms, and
x is a number average value indicating the number of repetitions, and is an integer of 20 to 150.

13. The method for producing a silicone-containing copolymer according to claim 12,
wherein the polymerizable monomer (A) is a compound represented by General Formula (a-1) described below, 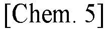 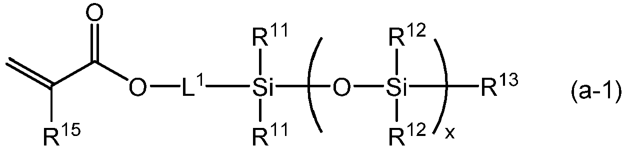 in General Formula (a-1) described above,
R¹¹, R¹², R¹³, and x are identical to R¹¹, R¹², R¹³, and x in General Formula (a) described above, respectively,
R¹⁵ is a hydrogen atom or a methyl group, and
L¹ is a divalent organic group.

14. The method for producing a silicone-containing copolymer according to claim 12 or 13,
wherein the polymerizable monomer (B) is a polymerizable monomer represented by General Formula (b-1) described below, 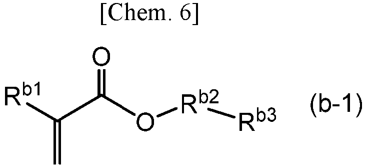 in General Formula (b-1) described above,
R^{b1} is a hydrogen atom or an alkyl group having 1 to 6 carbon atoms,
R^{b2} is an alkylene group having 1 to 10 carbon atoms, an arylene group having 6 to 18 carbon atoms, or a divalent linking group consisting of two or more types of combinations selected from an alkylene group having 1 to 10 carbon atoms, an arylene group having 6 to 18 carbon atoms and an ether bond (-O-), and
R^{b3} is a group including a cyclic hydrocarbon skeleton.

15. The method for producing a silicone-containing copolymer according to any one of claims 12 to 14,
wherein the group including the cyclic hydrocarbon skeleton has a bridged ring structure.

16. The silicone-containing copolymer according to any one of claims 12 to 15,
wherein the group including the cyclic hydrocarbon skeleton that has the bridged ring structure is an adamantane ring, a dicyclopentane ring, a dicyclopentene ring, a norbornane ring, a norbornene ring, a cyclohexane ring, or an isobornane ring.

17. The method for producing a silicone-containing copolymer according to any one of claims 12 to 16,
wherein the polymerization component is copolymerized by a random copolymerization method or a living copolymerization method.
